(19) Europäisches Patentamt
European Patent Office
Office européen des brevets

(11) **EP 4 344 068 A1**

(12) **EUROPEAN PATENT APPLICATION**
published in accordance with Art. 153(4) EPC

(43) Date of publication:
**27.03.2024 Bulletin 2024/13**

(21) Application number: **22804404.6**

(22) Date of filing: **29.03.2022**

(51) International Patent Classification (IPC):
*H03M 7/30* (2006.01)     *G06T 1/00* (2006.01)
*G06T 7/00* (2017.01)     *G06T 9/00* (2006.01)

(52) Cooperative Patent Classification (CPC):
**G06T 1/00; G06T 7/00; G06T 9/00; H03M 7/30**

(86) International application number:
**PCT/JP2022/015433**

(87) International publication number:
**WO 2022/244487 (24.11.2022 Gazette 2022/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.05.2021  JP 2021084606**

(71) Applicant: **Code Earth Co., Ltd.**
**Nagaoka-shi, Niigata-ken 940-2127 (JP)**

(72) Inventor: **KATAOKA Tadahisa**
**Nagaoka City Niigata 9402033 (JP)**

(74) Representative: **Patentwerk B.V.**
**P.O. Box 1514**
**5200 BN 's-Hertogenbosch (NL)**

(54) **CODE GENERATION METHOD, CODE GENERATION DEVICE, PROGRAM, AND DATA COLLATION METHOD**

(57)     A novel technology for encoding target data such as an image and an audio is provided. A code generation method for generating a code according to a content of target data using an information processing device is provided. The method includes a step of dividing the target data into a plurality of sampling ranges, a step of obtaining, for each of the sampling ranges, an average value of at least one data element among one or more types of data element included in each of the sampling ranges, each data element being represented by a numerical value, and a step of generating a reference code corresponding to the target data by concatenating, as character string data, the average values of the respective sampling ranges or numerals of a predetermined number of digits from a top digit of the average values.

Fig.1

135409101417106807191068121609621280
(E)

EP 4 344 068 A1

**Description**

TECHNICAL FIELD

The present invention relates to a code generation method, a code generation device, a program, and a data collation method.

BACKGROUND ART

A technique for identifying the content of target data by comparison and collation with reference data prepared in advance is known. A representative example of the technique is an image recognition technique (see, for example, Japanese Laid-Open Patent Publication No. 2019-28985). In the related art, there is room for improvement in that a learning time for obtaining reference data is enormous, or a processing load for comparison and collation with target data is large, and high-speed processing is difficult.

CITATION LIST

Patent Literature

Patent Literature 1: Japanese Laid-Open Patent Publication No. 2019-28985

SUMMARY OF INVENTION

Technical Problem

An objective of a specific aspect of the present invention is to provide a novel technology for encoding target data, such as an image and a sound, with a small amount of data.

Solution to Problem

[1] In one aspect of the present invention, a code generation method for generating a code according to a content of target data using an information processing device is provided. The method includes a step of dividing the target data into a plurality of sampling ranges, a step of obtaining, for each of the sampling ranges, an average value of at least one data element among one or more types of data element included in each of the sampling ranges, each data element being represented by a numerical value, and a step of generating a reference code corresponding to the target data by concatenating, as character string data, the average values of the respective sampling ranges or numerals of a predetermined number of digits from a top digit of the average values.

[2] In another aspect of the present invention, a code generation method for generating a code according to a content of target data using an information processing device is provided. The method includes a step of dividing the target data into a plurality of sampling ranges, a step of obtaining, for each of the sampling ranges, an average value of at least one data element among one or more types of data element included in each of the sampling ranges, each data element being represented by a numerical value, a step of obtaining, for each of the sampling ranges, a relative difference calculated by dividing an average value of each of the sampling ranges by a sum of average values of the sampling ranges, and a step of generating a code corresponding to the target data by concatenating, as character string data, the relative differences of the respective sampling ranges or numerals of a predetermined number of digits from a top digit of the relative differences.

[3] A program according to an aspect of the present invention is a program that causes an information processing device to execute the code generation method of the above [1] or [2].

[3] A code generation device according to an aspect of the present invention is a code generation device including a means that executes each step in the code generation method of the above [1] or [2].

[4] A data collation method according to an aspect of the present invention is a data collation method in which data collation is performed using the code generation method of the above [1] or [2].

According to the above configuration, a novel technology for encoding target data, such as an image and a sound, with a small amount of data is provided.

BRIEF DESCRIPTION OF DRAWINGS

Fig. 1 is a diagram for describing an encoding method according to a first embodiment.

Fig. 2 is a diagram illustrating a database configuration example of a code generated by the above-described method and content corresponding to each code.

Fig. 3 is a diagram conceptually describing a flow of collation using a database.

Fig. 4 is a diagram for describing a specific method of performing flexible collation.

Fig. 5 is a line graph illustrating a difference corresponding to each of the sampling ranges S1 to S9 in the example illustrated in Fig. 4.

Fig. 6 is a block diagram illustrating a configuration example of a code generation device for performing code generation using the above-described method.

Fig. 7 is a block diagram illustrating a configuration example of a user device that collates target data using a code generated by the above method.

Fig. 8 is a diagram illustrating a configuration example of a computer that implements an information processing unit in each of the code generation device and the user device.

Fig. 9(A) is a flowchart illustrating an operation procedure of the code generation device.

Fig. 9(B) is a flowchart illustrating an operation procedure of the user device.

Fig. 10 is a diagram for describing Application Example 1 of an encoding technology according to the above-described embodiment.

Fig. 11 is a diagram for describing Application Example 2 of an encoding technology according to the above-described embodiment.

Fig. 12 is a diagram for describing Application Example 3 of an encoding technology according to the above-described embodiment.

Fig. 13 is a diagram for describing Application Example 4 of an encoding technology according to the above-described embodiment.

Fig. 14 is a diagram for describing Application Example 5 of an encoding technology according to the above-described embodiment.

Fig. 15 is a diagram for describing Application Example 6 of an encoding technology according to the above-described embodiment.

Fig. 16 is a diagram for describing Application Example 7 of an encoding technology according to the above-described embodiment.

Fig. 17 is a diagram for describing an encoding method according to a second embodiment.

Fig. 18 is a diagram illustrating an example of a code written in a character code in hexadecimal.

Fig. 19 is a diagram for describing a collation method using a code of the second embodiment;

Fig. 20 is a diagram for describing an encoding method of a third embodiment.

Fig. 21 is a diagram for describing a collation method using a code of the third embodiment;

Fig. 22 is a conceptual diagram illustrating a method of using each embodiment.

DESCRIPTION OF EMBODIMENTS

First Embodiment

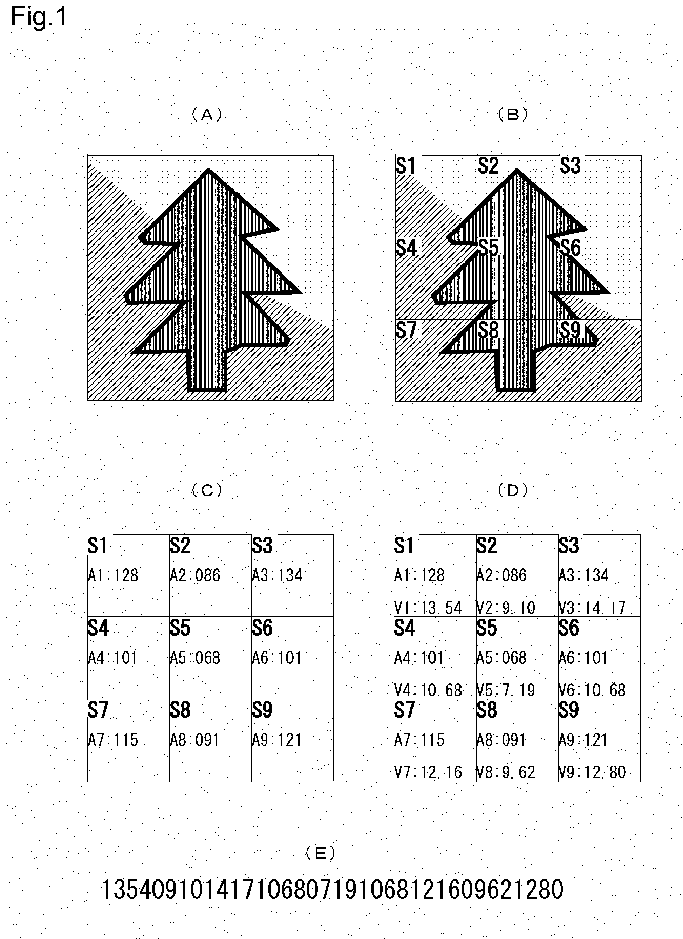

Fig. 1 is a diagram for describing an encoding method according to a first embodiment. Image data will be described as an example of data to be encoded (target data). In addition, encoding in the present specification means generating character string data that can identify target data on the basis of a predetermined numerical value included in the target data.

Image data as illustrated in Fig. 1 (A) is assumed as target data. The image data may be a color image or a monochrome image. The image data includes values (data elements) such as luminance, hue, saturation, and color difference for each pixel. In order to facilitate understanding, a description will be given using a luminance value as a data element.

As illustrated in Fig. 1(B), the image data is divided into multiple sampling ranges. The image data is divided into nine sampling ranges S1, S2, S3, ..., and S9. Each sampling range S1 and the like has, for example, a width and a height of forty pixels, and the total number of pixels included in each sampling range S1 and the like is 1600. In addition, the luminance value (the number of gradations) of each pixel is given by a numerical value in a range of 0 to 255.

Assuming that pixel values (here, luminance values) of pixels included in each sampling range S1 and the like are px1, px2, ..., and px1600, an average value of the pixel values in each sampling range S1 and the like is obtained as follows.

Total value of pixel values:

$$sumSx = px1 + px2 + px3 +... px1600$$

Average value of pixel values:

$$Ax = sumSx/1600$$

Fig. 1 (C) illustrates an example of an average value of pixel values in each sampling range S1 and the like. In the illustrated example, an average value A1 of the sampling range S1 is 128, an average value A2 of the sampling range S2 is 86, an average value A3 of the sampling range S3 is 134, an average value A4 of the sampling range S4 is 101, an average value A5 of the sampling range S5 is 68, an average value A6 of the sampling range S1 is 101, an average value A7 of the sampling range S7 is 115, an average value A8 of the sampling range S8 is 91, and an average value A9 of the sampling range S9 is 121.

Next, a relative difference between the average values in each sampling range S1 and the like is obtained as follows.

Total value of average values:

$$sumA = A1 + A2 + A3 +...+ A9 = 945$$

Relative difference of average values:

$$Vx = (100 \times Ax)/945$$

Fig. 1(D) illustrates an example of a relative difference between average values in each sampling range S1 and the like. In the illustrated example, a relative difference V1 of the sampling range S1 is 13.54%, a relative difference V2 of the sampling range S2 is 9.10%, a relative difference V3 of the sampling range S3 is 14.17%, a relative difference V4 of the sampling range S4 is 10.68%, a relative difference V5 of the sampling range S5 is 7.19%, a relative difference V6 of the sampling range S6 is 10.68%, a relative difference V7 of the sampling range S7 is 12.16%, a relative difference V8 of the sampling range S8 is 9.62%, and a relative difference V9 of the sampling range S9 is 12.80%.

Using the relative difference in each sampling range S1 and the like, numerals (four digits in total) of digits from the top digit to the second decimal place of each relative difference are extracted as character string data. For example, the character string data 1354 is extracted from the sampling range S1. When there is no value in the tens place or when there is no value in the digits after the decimal point, the value is set to 0. For example, 0910 is extracted from 9.1%.

In this way, the character string data extracted from each sampling range S1 and the like is concatenated. The concatenation order is not particularly limited, and can be arbitrarily determined. The sampling ranges S1, S2, ..., and S9 are concatenated in this order. As a result, in the example described above, the character string data 135409101417106807191068121609621280 is obtained (see Fig. 1(E)). In the present embodiment, the character string data generated in this way is used as a code corresponding to the target data.

The relative difference is not necessarily expressed as a percentage. Furthermore, the order of concatenation of the character string data corresponding to each sampling range is arbitrary as long as a predetermined order is always used, and for example, it can be determined that the sampling ranges S9, S8, ..., and S1 are concatenated in this order. In addition, it is also arbitrary how many digits of the relative difference is used in each sampling range. The number of divisions of the sampling range is also arbitrary. When the number of divisions of the sampling range is reduced, the collation can be performed more simply and at a high speed. On the other hand, when the number of divisions of the sampling range is increased, the collation can be performed with higher accuracy.

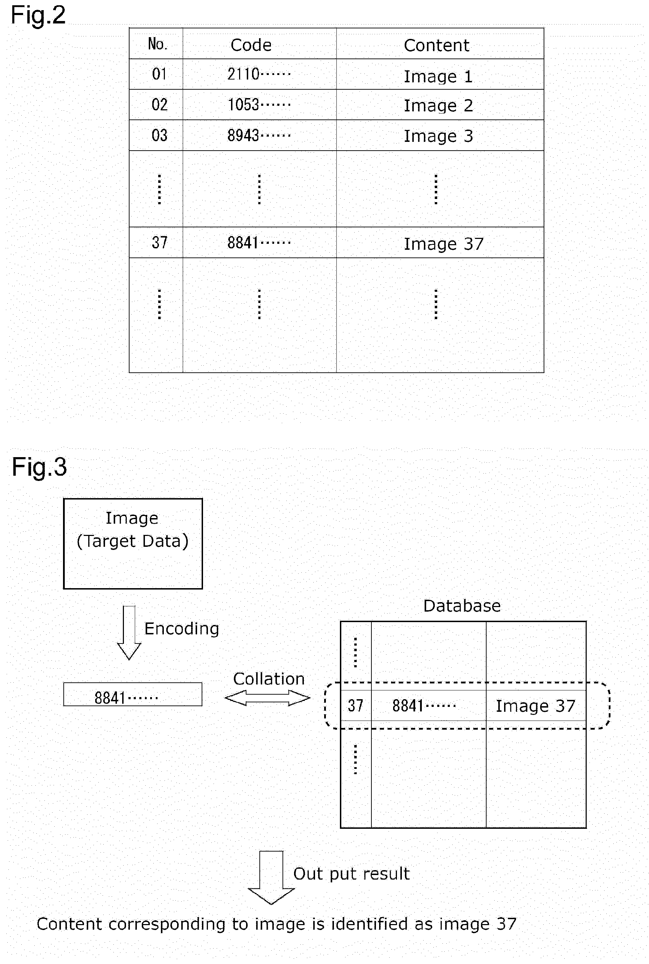

Fig. 2 is a diagram illustrating a database configuration example of a code generated by the above-described method and content corresponding to each code. An image is taken as an example of content. As illustrated in the drawing, codes corresponding to the images 1, 2, ... are generated in advance by the above method, and a database in which the codes are associated with each other is constructed. For example, the image 1 corresponds to a code 2110..., and the image 2 corresponds to a code 1053.... The images 1, 2, ... as content may be image data itself or may include data of additional information (for example, a character string representing an object or the like included in an image, position information in a real space, time information, and other arbitrary additional information) corresponding to the content of the image data. By constructing such a database in advance, it is possible to collate which content the specific target data corresponds to by using each code of the database as reference data.

Fig. 3 is a diagram conceptually describing a flow of collation using a database. For example, image data obtained by photographing is encoded by the above method, and a specific target code (8841... in the illustrated example) that is a code corresponding to the image data is generated. The generated specific target code is collated with each reference code in the database. When a reference code matching the generated specific target code is present in the database, content (an image 37 in the illustrated example) corresponding to the captured image is identified.

An example will be described in which image data obtained by photographing an arbitrary space using a terminal device (for example, a smartphone) equipped with a camera is obtained. In this example, an application program capable of executing the above-described encoding is installed in advance in the terminal device, and a database as illustrated in Fig. 2 is stored. The database may be placed in a server that can communicate with the terminal device via a network. In this case, for example, when content corresponding to an image of a landscape captured by the user with the camera is identified, it is possible to display information related to the content on the screen of the terminal device of the user.

According to the study of the inventor of the present application, it has been found that if target data is image data obtained by photographing a space, it is possible to perform collation and determination practically with necessary and sufficient accuracy by performing encoding with the sampling range set to sixty-four or more. The data amount of the code generated under this condition is about 192 bytes, which is considered to be a significantly small data amount.

According to the principle of collation described with reference to Fig. 3, when all pieces of character string data of the codes match, it is determined that the content corresponding to each code is the same. By setting an allowable range at the time of determination as follows, more flexible collation can be performed.

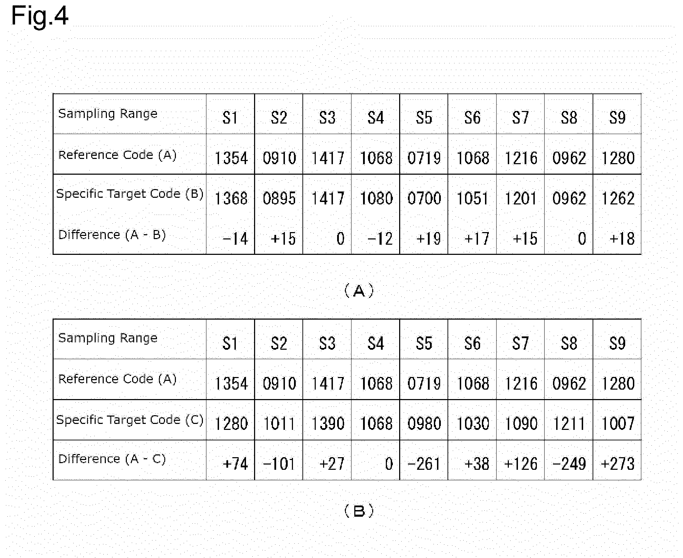

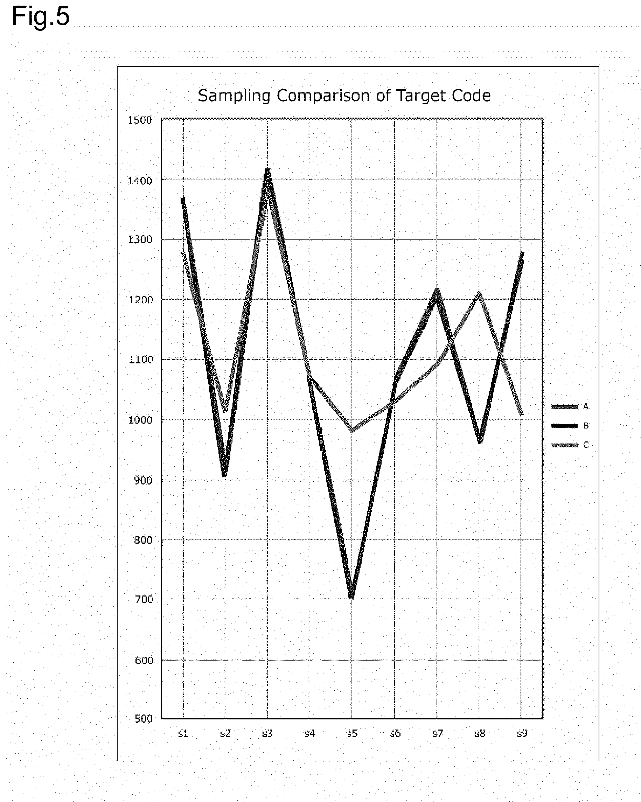

Fig. 4 is a diagram for describing a specific method of performing flexible collation. Fig. 5 is a line graph illustrating a difference corresponding to each of the sampling ranges S1 to S9 in the example illustrated in Fig. 4.

In the example illustrated in Fig. 4(A), the character string data of each of a reference code A and a specific target code B is separated by four digits corresponding to the sampling range described above, each character string data is treated as a four-digit numerical value. A numerical value difference (A-B) is obtained for each corresponding sampling range. For example, since the numerical value corresponding to the sampling range S1 is 1354 in the reference code and 1368 in the specific target code, the difference between them is -14. Similarly, the differences for the other sampling ranges S2 to S9 are +15, 0, -12, +19, +17, +15, 0, and +18. At this time, if an allowable range of the difference corresponding to each sampling range is set, for example, to ±20 in advance the difference corresponding to any of the sampling ranges S1 to S9 falls within this allowable range in the example illustrated in Fig. 4(A). In such a case, it is determined that the reference code and the specific target code are "the same (matched)". As illustrated in Fig. 5, when it is determined that the reference code and the specific target code are the same (A and B), the graphs substantially overlap. On the other hand, in the example illustrated in Fig. 4(B), for the character string data of each of the reference code A and a specific target code C, the differences for each of the sampling ranges S1 to S9 are +74, -101, +27, 0, -261, +38, +126, -249, and +273. If the allowable range of the difference corresponding to each sampling range is predetermined as ±20, in the example illustrated in Fig. 4(B), only the difference corresponding to the sampling range S4 falls within the allowable range, and the differences corresponding to the other sampling ranges do not fall within the allowable range. In such a case, it is determined that the reference code and the specific target code are "different (mismatch)". In this case, as illustrated in Fig. 5, when it is determined that the reference code and the specific target code are different from each other (A and C), the graphs do not overlap each other.

If the allowable range is not provided, it means that the image capturing conditions (reflected light, ambient light, and the like) are exactly the same. On the other hand, in a case where the allowable range is provided, it is possible to derive a "solution" corresponding to a subtle environmental change such as the state of light or the sensation experienced by the user. By using this allowable range (environmental variable), it is possible to achieve judgement close to sensation by human eyes (like "it might be..."). The size of the allowable range can be arbitrarily set, but is preferably set to about ±20 as described above according to the study of the inventor of the present application.

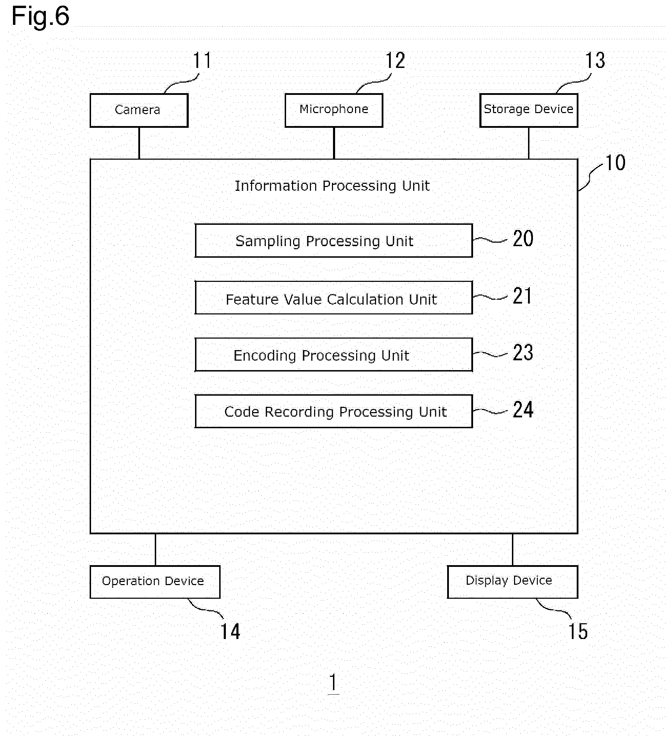

Fig. 6 is a block diagram illustrating a configuration example of a code generation device for performing code generation using the above-described method. A code generation device 1 illustrated in the drawing includes an information processing unit 10, a camera 11, a microphone 12, a storage device 13, an operation device 14, and a display device 15.

The information processing unit 10 performs information processing related to code generation. The information processing unit 10 includes, as functional blocks, a sampling processing unit 20, a feature value calculation unit 21, an encoding processing unit 23, and a code recording processing unit 24. The information processing unit 10 is implemented by using a computer including, for example, a central processing unit (CPU), a read-only memory (ROM), a random-access memory (RAM), and the like and causing the computer to execute a predetermined operation program. In the present embodiment, the sampling processing unit 20 corresponds to a "dividing unit", the feature value calculation unit corresponds to an "average value calculation unit" and a "relative difference calculation unit", and the encoding processing unit 23 corresponds to a "code generation unit".

The camera 11 photographs a space, an object, or the like that can be a target of code generation and generates an image thereof. The image referred to herein is not necessarily limited to an image in the visible light range, and may be, for example, a thermal image or an infrared image. The camera 11 outputs image data (or an image signal) of the captured image to the information processing unit 10.

The microphone 12 collects a sound that can be a target of code generation and converts the sound into an electric signal. The sound mentioned here is not necessarily limited to a sound in the audible range, and may be an ultrasonic wave, a low-frequency sound, or the like. The sound signal output from the microphone 12 is output to the information processing unit 10, and is converted into digital data in the information processing unit 10 to be captured.

The storage device 13 stores programs and various data necessary for the configuration and operation of the information processing unit 10, and stores a database of codes generated by the information processing unit 10. The storage device 13 is a nonvolatile storage device such as a hard disk drive (HDD) or a solid state drive (SSD).

The operation device 14 is used for inputting information necessary for the operation of the information processing unit 10, and may include, for example, a keyboard, a mouse, a switch, a touch panel, and the like. The display device 15 is used to display information regarding the operation of the information processing unit 10, and for example, a liquid crystal display device, an organic EL display device, or the like is used.

The sampling processing unit 20 performs processing of dividing code generation target data into multiple sampling ranges (see Fig. 1(B)). The target data is, for example, image data or sound data. In the case of sound data, sound data included in the sections divided at predetermined time intervals can be set as data corresponding to each sampling range (see a third embodiment to be described later).

The feature value calculation unit 21 obtains an average value of the predetermined data included in each sampling range divided by the sampling processing unit 20 (see Fig. 1(C)), and obtains a relative difference between the average values corresponding to each sampling range (see Fig. 1(D)). The relative difference is expressed as a percentage, for example, as in the example described above, but is not limited thereto.

The encoding processing unit 23 generates a code (a code obtained by concatenating character string data) corresponding to the target data by using the relative difference (or the average value) corresponding to each sampling range calculated by the feature value calculation unit 21.

The code recording processing unit 24 associates the code generated by the encoding processing unit 23 and data of information for identifying content corresponding to the code and records the cord and the data in the storage device 13, and generates a database of codes (see Fig. 2).

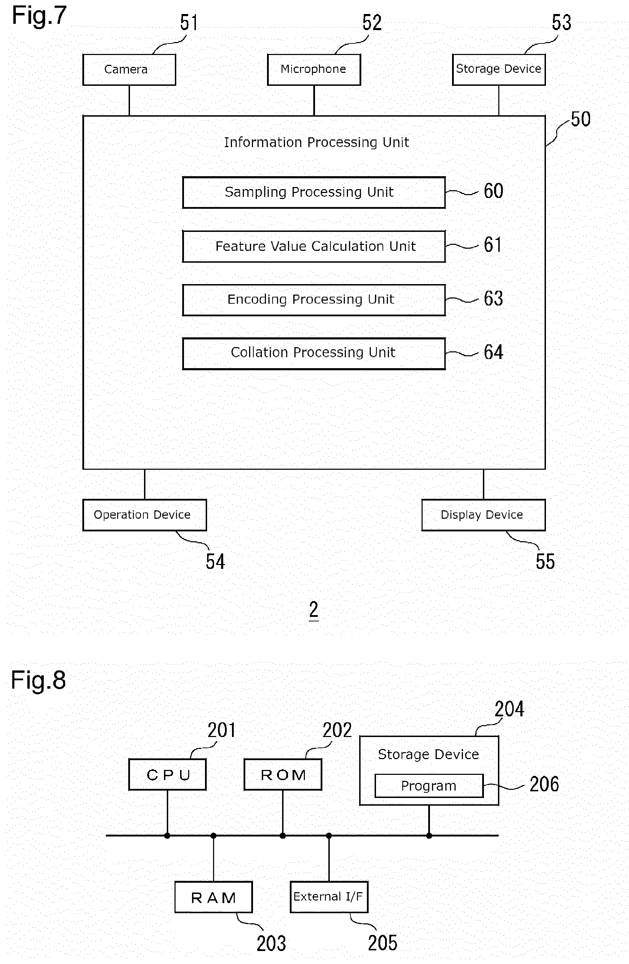

Fig. 7 is a block diagram illustrating a configuration example of a user device that collates target data using a code generated by the above method. The illustrated user device 2 includes an information processing unit 50, a camera 51, a microphone 52, a storage device 53, an operation device 54, and a display device 55. The user device 2 is implemented, for example, by installing a predetermined application program in advance in an information processing device such as a smartphone owned by the user.

The information processing unit 50 performs information processing related to code collation. The information processing unit 50 includes, as functional blocks, a sampling processing unit 60, a feature value calculation unit 61, an encoding processing unit 63, and a collation processing unit 64. The information processing unit 50 is implemented by using a computer including, for example, a central processing unit (CPU), a read-only memory (ROM), a random-access memory (RAM), and the like and causing the computer to execute a predetermined operation program.

The configurations and operations of the camera 51, the microphone 52, the storage device 53, the operation device 54, and the display device 55 are similar to those of the camera 11, the microphone 12, the storage device 13, the operation device 14, and the display device 15 in the code generation device 1 described above, and thus detailed description thereof will be omitted here. The configuration and operation of each of the sampling processing unit 60, the feature value calculation unit 61, and the encoding processing unit 63 are also similar to those of the sampling processing unit 20, the feature value calculation unit 21, and the encoding processing unit 23 in the code generation device 1 described above, and thus detailed description thereof is omitted here.

The collation processing unit 64 of the information processing unit 50 collates the specific target code obtained by each processing of the sampling processing unit 60, the feature value calculation unit 61, and the encoding processing unit 63 with the database (see Fig. 2) stored in advance in the storage device 53, and identifies the content corresponding to the specific target code. A specific collation method by the collation processing unit 64 may be a method on the condition of perfect matching between the codes, or may be a flexible method in which an allowable range is provided for the difference between the codes as described above. The identification result is displayed on the display device 55, for example.

Fig. 8 is a diagram illustrating a configuration example of a computer that implements an information processing unit in each of the code generation device and the user device. The computer illustrated in the drawing includes a CPU 201, a ROM 202, a RAM 203, a storage device 204, and an external interface (I/F) 205 connected to communicate with each other. The CPU 201 operates on the basis of the basic control program read from the ROM 202, and reads and executes the program (application program) 206 stored in the storage device 204 to implement the above-described functions of the controller 13. The RAM 203 temporarily stores data to be used at the time of operation of the CPU 201. The storage device 204 is, for example, a nonvolatile storage device such as a hard disk or a solid state drive, and stores various data such as the program 206. The external interface 205 is an interface for connecting the CPU 201 and an external device, and is used for connecting the camera 11 (51), the microphone 12 (52), the operation device 14 (54), the display device 15 (55), and the CPU 201, for example.

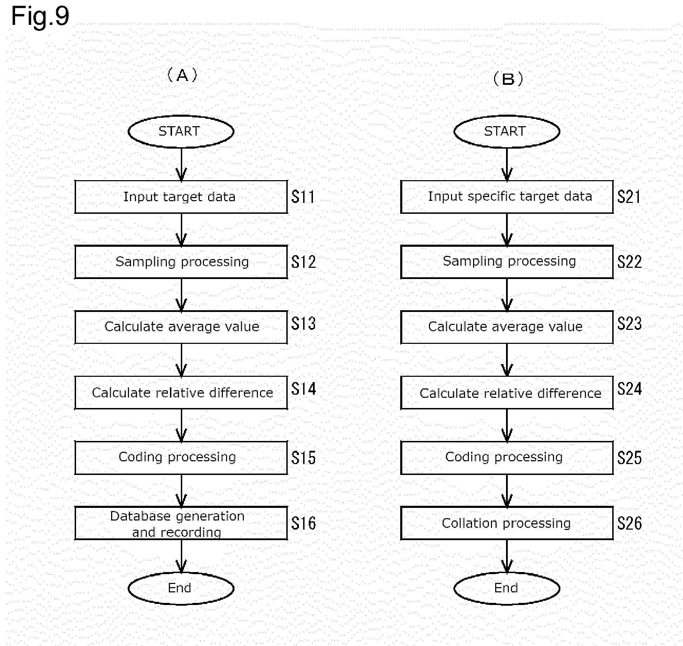

Fig. 9(A) is a flowchart illustrating an operation procedure of the code generation device. Fig. 9(B) is a flowchart illustrating an operation procedure of the user device. In any of the operation procedures, the processing order can be changed as long as no contradiction or inconsistency occurs in the result of the information processing, and other processing not mentioned here may be added, and these embodiments are not excluded.

First, an operation procedure of the code generation device will be described.

When target data is input to the code generation device 1 (step S11), the sampling processing unit 20 performs processing of dividing the target data into multiple sampling ranges (step S12). The target data may be image data input from the camera 11, sound data corresponding to a signal input from the microphone 12, or image data or sound data stored in advance in the storage device 13. Alternatively, the data may be transmitted from a server or the like (not illustrated) via a network and received by the code generation device 1.

Next, the feature value calculation unit 21 obtains an average value of the predetermined data element included in each sampling range divided by the sampling processing unit 20 (step S13). The data element here may be any data that is included in the target data as described above and that defines the content, feature, or characteristic of the target data. For example, as described above, in the case of the image data, the luminance or the like of each pixel may be used, and in the case of the sound data, the loudness of the sound may be used for each predetermined sampling time.

Next, the feature value calculation unit 21 obtains a relative difference between the average values corresponding to the respective sampling ranges (step S14). The relative difference is expressed as a percentage as in the example described above, for example, but is not limited thereto.

Next, the encoding processing unit 23 generates a reference code (a code obtained by concatenating character string data) corresponding to the target data by using the relative difference corresponding to each sampling range calculated by the feature value calculation unit 21 (step S15).

Next, the code recording processing unit 24 records the reference code generated by the encoding processing unit 23 and data of information for identifying content corresponding to the reference code in the storage device 13 in association with each other, and generates a database of reference codes (see Fig. 2) (step S16).

The series of information processing described above is repeatedly executed a necessary number of times, whereby the reference code corresponding to each of the contents is generated, and the database including the information is obtained. The generated database may be transmitted to and stored in a server device or the like (not illustrated) communicably connected via a network. This allows the database to be shared by multiple users via the network.

Next, an operation procedure of the user device will be described.

When specific target data is input to a user device 2 (step S21), the sampling processing unit 60 performs processing of dividing the specific target data into multiple sampling ranges (step S22). The specific target data here may be image data input from the camera 11, sound data corresponding to a signal input from the microphone 12, or image data or sound data stored in advance in the storage device 13.

Next, the feature value calculation unit 61 obtains an average value of the predetermined data element included in each sampling range divided by the sampling processing unit 60 (step S23). The data element here may be any data that is included in the target data as described above and that defines the content, feature, or characteristic of the target data.

Next, the feature value calculation unit 61 obtains a relative difference between the average values corresponding to the respective sampling ranges (step S24).

Next, the encoding processing unit 63 generates a specific target code (a code obtained by concatenating character string data) corresponding to the specific target data by using the relative difference corresponding to each sampling range calculated by the feature value calculation unit 61 (step S25).

Next, the collation processing unit 64 refers to a database stored in advance in the storage device 53 and identifies the content corresponding to the specific target code generated in step S25 (step S26). The identification result is displayed on the display device 55. The database stored in the storage device 53 is, for example, transmitted from a server or the like (not illustrated) via a network and received by the user device 2.

The above is the basic content related to code generation and collation of the first embodiment, and next, some application examples thereof will be described. Code generation and collation according to the following application examples are both executed by the code generation device 1 and the user device 2 (or another device).

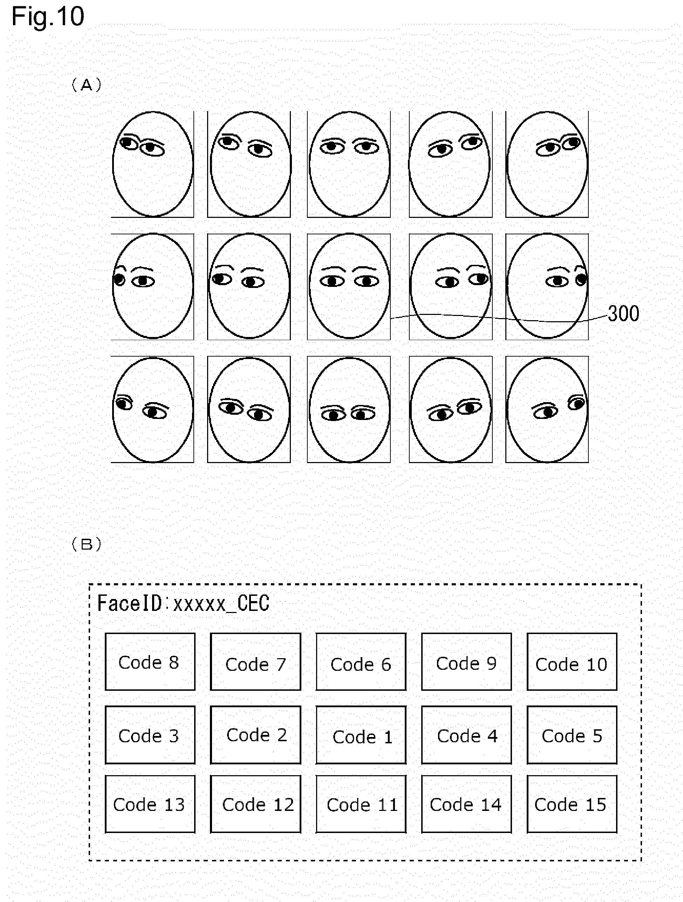

Fig. 10 is a diagram for describing Application Example 1 of the encoding technology according to the above-described embodiment. An application example of face authentication technology is illustrated. The face authentication technology here refers to a technology for identifying a person corresponding to a face included in a certain image. The certain image may be a still image or a moving image captured by a camera. In the case of a moving image, a still image obtained for each frame can be used. As illustrated in Fig. 10(A), face image data 300 from the front of a certain person is given. For the face image data 300, face image data corresponding to the person viewed from each of the upper, lower, left, and right directions is automatically generated using a known technique. The image may be directly captured from the person instead of the automatic generation. A total of fifteen pieces of face image data including the front face image data 300 and face image data automatically generated (or photographed) around the front face image data corresponding to the upper, lower, left, and right directions are illustrated.

The above code generation device 1 encodes the face image data as illustrated in Fig. 10(B) to obtain a reference code. A code 1 corresponding to the front face image data 300 and codes 2 to 15 corresponding to face image data in the other upper, lower, left, and right directions are obtained. The fifteen codes 1 to 15 are associated as a set of face authentication data. For example, it is possible to assign identification information such as "xxxxx_CEC" to each code as the identification information (Face ID) and associate the codes with the identification information. In addition, the identification information is associated with attribute information (for example, name, age, affiliation, and the like) regarding a person to be identified.

By generating and storing such face authentication data in advance, for example, the user device 2 (or another device) can perform the face authentication on the basis of the image data obtained from the camera in real time. Various specific collation methods are conceivable, and for example, if there is a match in any one of the codes 1 to 15, the person may be identified, or it may be conditional that multiple codes match. The code obtained by the encoding technology of the present exemplary embodiment is irreversible character string data (text data) and does not use the face image data itself, for example, when the face authentication data is stored on the network server. Thus, even if information is leaked, privacy is protected. In addition, since the data size of one code is several hundred bytes, the amount of data required for the face authentication is dramatically reduced. For example, assuming that the data size of one piece of face image data is 100 kilobytes, the amount of data of fifteen pieces of face image data is 1500 kilobytes, whereas the data size of one code can be, for example, about 192 bytes, so that the amount of data of fifteen codes is also 2880 bytes, and the difference in amount of data is remarkable.

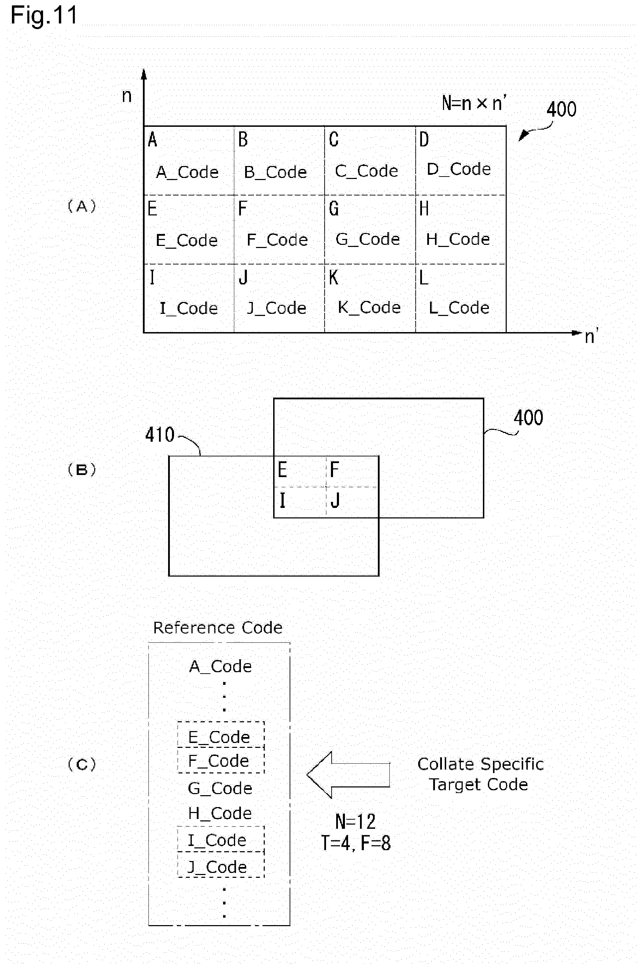

Fig. 11 is a diagram for describing Application Example 2 of the encoding technology according to the above-described embodiment. An application example in a case where image data such as a space is divided into multiple partial images, a code is generated with each partial image, and image recognition (space recognition) is performed is described. Specifically, as illustrated in Fig. 11(A), image data 400 as the target data is divided into multiple (here, twelve) partial images A to L by the code generation device 1. Then, the encoding is performed on each of the partial images A to L. A code generated corresponding to the partial image A is denoted as A_code. The same applies to codes corresponding to other partial images. The twelve codes such as the A_code generated in this manner are recorded in association as one reference code group.

Similarly, the image data as the specific target data is divided into multiple partial images by the user device 2 (or another device), and a code corresponding to each partial image is generated. For example, code generation is performed on a still image captured in real time by a camera of the user or an image of one frame of a moving image. At this time, for example, as illustrated in Fig. 11(B), the photographing range of the image data 400 corresponding to the reference data group partially overlaps image data 410 as the specific target data by the user. Portions corresponding to the partial images E, F, I, and J overlap.

In this state, when a code group generated from the image data 410 as the specific target data is referred to in a brute-force manner with respect to the reference code group, the number T of matching partial images = 4 and the number F of non-matching partial images = 8 with respect to the total number N of partial images = 12 (see Fig. 11(C)). When the matching rate (recognition rate) is defined as T/N and the mismatching rate is defined as F/N, the matching rate is about 33% (T/N = 4/12) and the mismatching rate is about 66% (F/N = 8/12) in this example. The percentage at or over which it is determined that the specific target data and the reference data match each other depends on the application, and can be set appropriately. The matching rate can also be used to determine similarity. For example, if the matching rate is about 33% as described above, it is possible to determine that there is a high possibility of resemblance or that the images were taken from nearby locations. Using such a method, it is possible to accommodate any kind of framing. Furthermore, as the total number N of partial images increases, the recognition accuracy is improved. Even in this case, since search, collation, and determination are performed by text data, high-speed processing equivalent to generally known text search is performed.

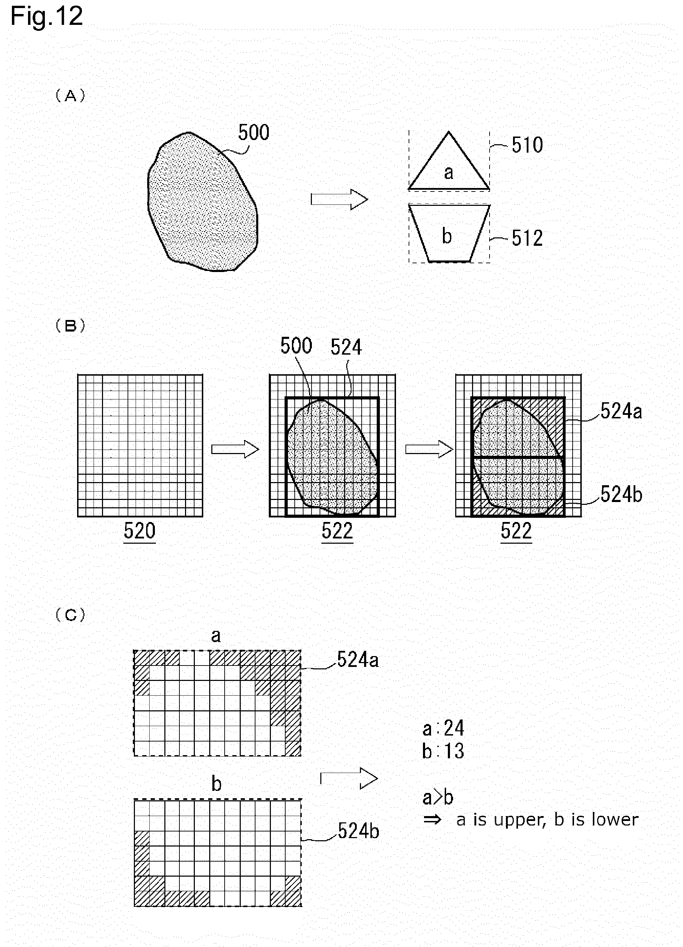

Fig. 12 is a diagram for describing Application Example 3 of the encoding technology according to the above-described embodiment. An application example in a case where the vertical direction of the object is determined is illustrated. The object is not particularly limited as long as it has an asymmetric shape in the vertical direction. For example, there is a case where the vertical direction is determined in order to break a pistachio nut with an industrial machine.

As illustrated in Fig. 12(A), a certain object 500 is divided into two portions a and b focusing on asymmetry in the vertical direction. As an example, the portion a is regarded as a triangle, and the portion b is regarded as a trapezoid. The base of the portion a and the lower base of the portion b are equal, and the heights of the portions are also equal. When the portions a and b are applied to regions 510 and 512 (rectangular regions indicated by dotted lines in the drawing) having the same size and the remaining portions other than the portions a and b are compared, the rectangular region 510 corresponding to the portion a has a larger remaining portion than the rectangular region 512 corresponding to the portion b. Based on such knowledge, the encoding technology is applied.

Specifically, as illustrated on the left side of Fig. 12(B), first, a region to be a base is photographed in a state where the object 500 does not exist, image data 520 is divided into multiple (several hundreds as an example) partial images, reference codes corresponding to the partial images are generated, and the reference code group is recorded.

Next, as illustrated in the center of Fig. 12(B), the edge of the object 500 is detected on the basis of the image data 522 obtained by photographing the region in a state where the object 500 is arranged in the base area, and an effective region 524 (rectangular region indicated by thick line in the drawing) in which the object 500 exists is extracted. As illustrated in Fig. 12(B), the inside of the extracted rectangular region 524 is divided such that the upper and lower half regions have the same number of partial images, and each partial image is encoded. The manner of dividing the partial image is similar to that at the time of generating the reference code group.

Next, when the specific target code group generated in the state where the object 500 is arranged is collated with the reference code group, the codes corresponding to the regions where the object exists do not match, and the codes corresponding to the other regions match. In Fig. 12(B), regions where codes match each other are indicated by hatching. As illustrated in Fig. 12(C), the number of regions in which the codes match is counted by dividing the region into an upper half region 524a and a lower half region 524b of the effective region. In the illustrated example, twenty-four codes are matched in the upper half region 524a of the effective region, and thirteen codes are matched in the lower half region 524b. In this case, since the upper half region 524a of the effective region corresponds to the above-described portion a, it can be determined as "upper", and since the lower half region 524b of the effective region corresponds to the above-described portion b, it can be determined as "lower".

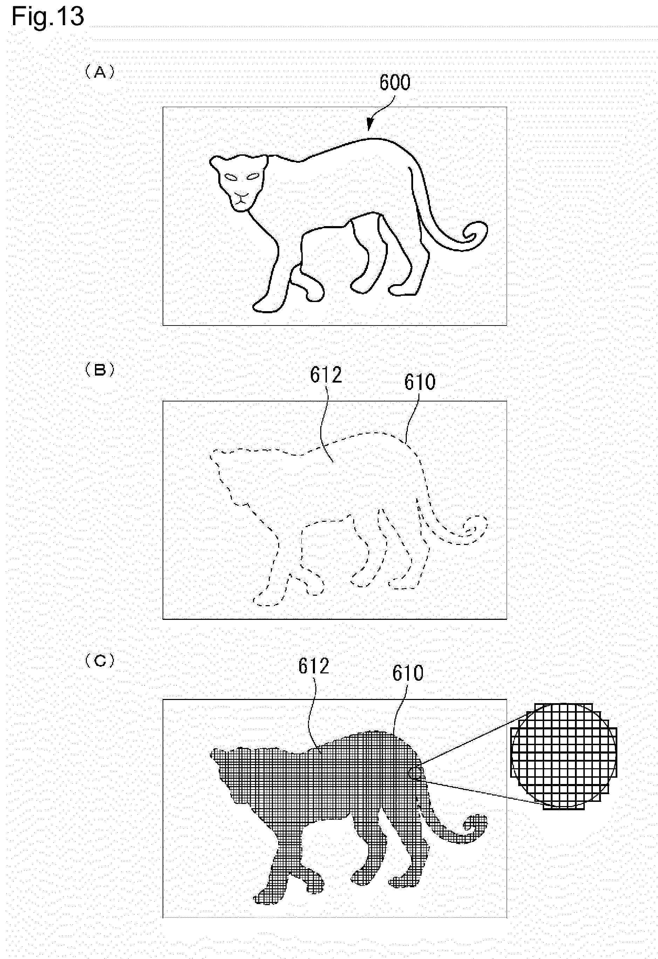

Fig. 13 is a diagram for describing Application Example 4 of the encoding technology according to the above-described embodiment. An application example in a case where an object (for example, an animal) in a video (image) is encoded in advance and the object existing in the video is recognized using the reference code group is illustrated. Specifically, first, as illustrated in Fig. 13(A), an object 600 (here, an animal) in a video is subjected to edge detection by a known technique, and as illustrated in Fig. 13(B), an edge 610 of the object is extracted. Next, as illustrated in Fig. 13(C), multiple rectangular regions are mapped to the extracted edge 610 and its internal region 612. The number of rectangular regions can be arbitrarily set, and the recognition accuracy can be improved as the number increases. Then, for the mapped partial image of each rectangular region, a reference code corresponding to each partial image is generated by the above-described method, and the reference code group is recorded. Similarly, a reference code group corresponding to each imaging direction of the object or the like is generated and recorded. Information regarding the object (for example, in the case of an animal, attribute information such as a name thereof) is recorded in association with these reference code groups.

Next, for example, from the video captured in real time, the edge detection of the object and the mapping of the rectangular region are performed in the same manner as described above, the partial image of each rectangular region is encoded, and the specific target code group corresponding to the object in the video is generated. By collating the specific target code group with the reference code group recorded in advance, it is possible to recognize the object included in the video and to identify attributes such as presence or absence and a name of the object.

In this way, by combining the existing edge detection technology and the encoding technology of the present embodiment, it is possible to immediately register and immediately collate codes, and improve recognition accuracy. The same applies to a case where the object is space or electronic data. Since the encoding technology of the present embodiment can realize generation, registration, comparison, collation, and determination in real time, recognition accuracy and recognition speed can be improved.

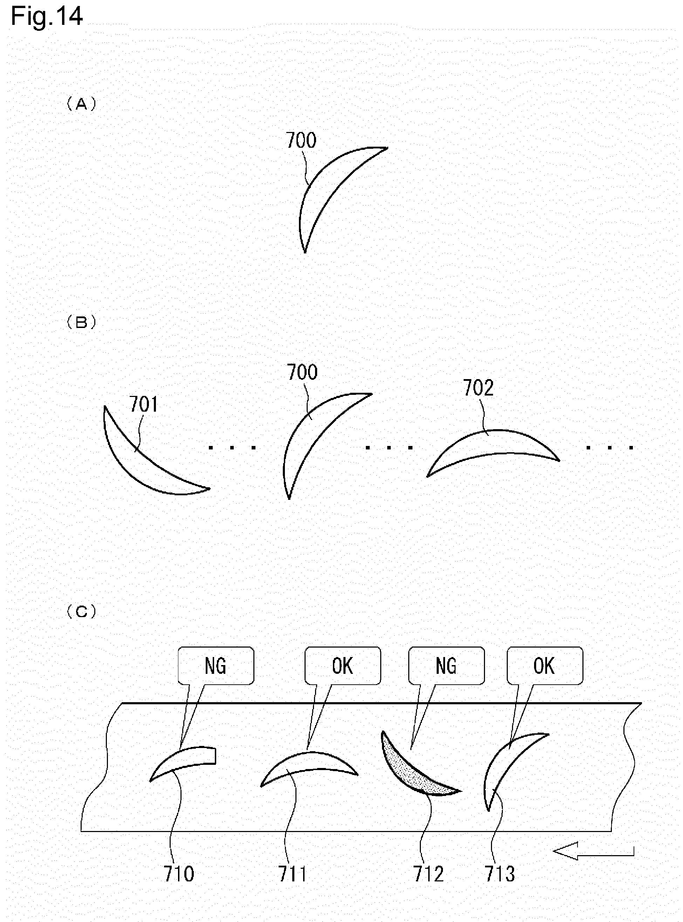

Fig. 14 is a diagram for describing Application Example 5 of the encoding technology according to the above-described embodiment. For example, an application example of an appearance inspection process at the time of manufacturing an industrial product is shown. Specifically, first, as illustrated in Fig. 14(A), the appearance of a product to be inspected is photographed to obtain image data 700. Next, as illustrated in Fig. 14(B), the image data 700 is rotated 360° by every arbitrary angle (for example, every 1°) to obtain image data 701 and 702, and the like at each angle. Then, encoding is performed on the basis of the image data of each angle, and each code is recorded as a reference code. Next, as illustrated in Fig. 14(C), in the actual appearance inspection process, a code is generated from image data 710 to 713 obtained, for example, by photographing each product flowing on a belt, and the code is collated with a reference code recorded in advance. As a result, even if the angle of arrangement of the product is not constant, it can be determined as a passed product (OK product) when the shape, color tone, and the like match, and it can be determined as a defective product (NG product) when there is a partial defect, a difference in color tone, or the like. In the illustrated example, it can be determined that the products corresponding to the image data 711 and 713 are passed products, and the products corresponding to the image data 710 and 713 are defective products.

In this way, when the reference code is generated in advance, if one conforming product (product without defect) is photographed in one arrangement state (angle), multiple reference codes that can be identified even if the direction or angle is changed by the in-memory processing can be automatically generated. Furthermore, by embedding color information in the code, not only the shape but also the color tone can be determined.

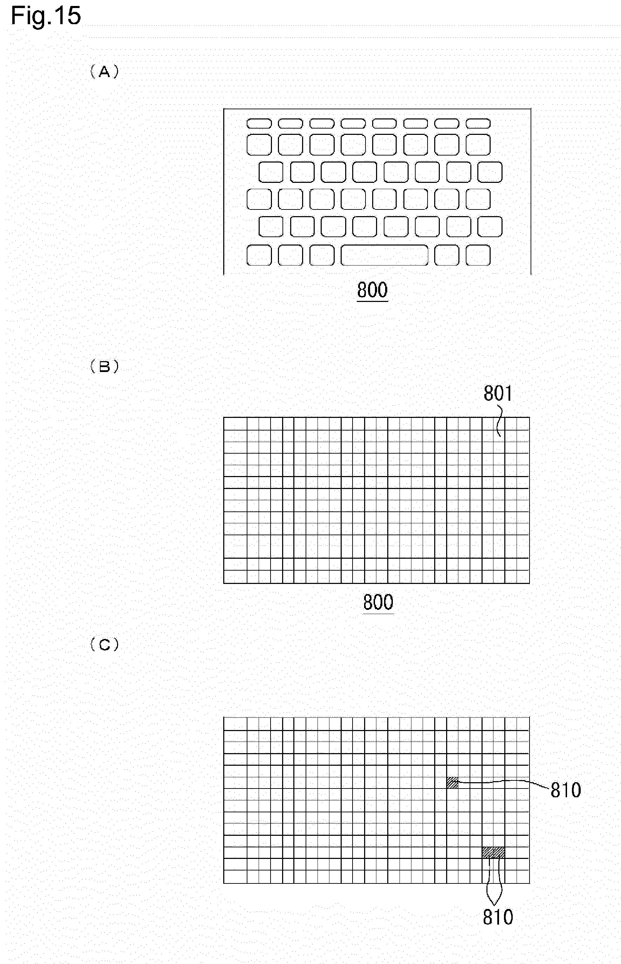

Fig. 15 is a diagram for describing Application Example 6 of the encoding technology according to the above-described embodiment. For example, when it is determined that the product flows in a certain arrangement in the appearance inspection process of the product, it is not necessary to generate a reference code with a changed angle. In this case, one reference code corresponding to a conforming product arranged in a fixed manner can be used. As an example, a case of detecting a defect such as a deficit, a printing defect, or a scratch of a keyboard for a personal computer is considered.

First, as shown in 15(A), the appearance of a product to be inspected is photographed to obtain image data 800, encoding is performed, and the image data is recorded as a reference code. At this time, as illustrated in Fig. 15(B), it is preferable to divide the image data 800 of the target product into multiple rectangular regions to obtain partial images 801 corresponding to the respective regions, and to obtain a reference code group, which is a set of reference codes corresponding to the respective partial images 801. Next, in the actual appearance inspection process, for example, a specific target code (group) is generated from image data obtained by photographing each product flowing on the belt, and collated with a reference code (group) recorded in advance. Accordingly, when there is a defect such as a keyboard deficit, a printing defect, or a scratch, the defect can be detected. In this case, as illustrated in Fig. 15(C), it is also possible to identify the region 810 where the defect exists based on the reference code that does not match.

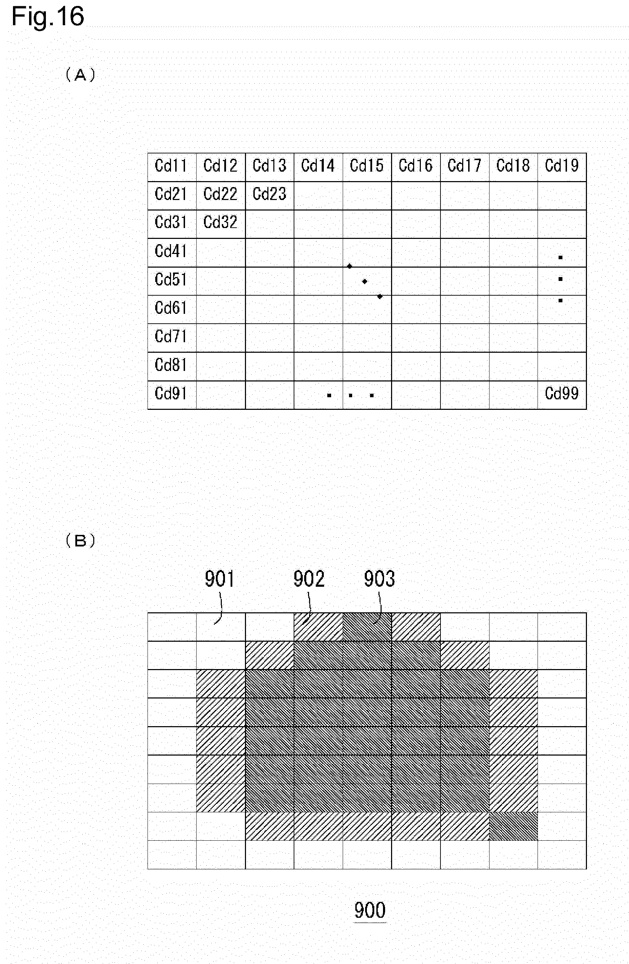

Fig. 16 is a diagram for describing Application Example 7 of the encoding technology according to the above-described embodiment. A method of obtaining the shape and area of the object will be described. The object is arranged in a certain imaging region and captured. In this case, first, image data of the imaging region is obtained in a state where the object is not arranged, the image data is divided into multiple regions, and encoding is performed on a partial image of each region. As a result, as illustrated in Fig. 16(A), a reference code group including multiple (eighty-one in the illustrated example) codes Cd11, Cd12... Cd99 is obtained, and thus this reference code group is recorded.

Next, the image data of the imaging region in which the object is arranged is obtained, divided into multiple regions, and the partial image of each region is encoded. As a result, a specific target code group is obtained. This is compared with the reference code group. Then, as illustrated in Fig. 16(B), a region 901 in which codes match (non-patterned rectangular region in the drawing) and regions 902 and 903 in which codes do not match (patterned rectangular regions in the drawing) are obtained. The regions 902 and 903 in which the codes do not match are regions in which the object exists. The matching rate is divided into several ranges each having a size of 10%. An edge, that is, a shape of the object is obtained by connecting the regions 902 having matching rates of 30% to 40% in the illustrated example among the regions in which the codes do not match. In addition, the area of the object in plan view can be obtained by obtaining the area in the edge. Furthermore, the unevenness of the object can also be estimated on the basis of a portion of the region 903 (here, for example, a matching rate of 60% to 70%) having different matching rates in the edge. Various methods of obtaining the matching rate between the codes can be considered, but as a simple example, a method of comparing the codes one by one in their arrangement order, counting the number of matched characters, and dividing the number by the total number of characters can be used. For example, when 384 characters are included in the code and 370 characters match, the matching rate is about 96%.

Second Embodiment

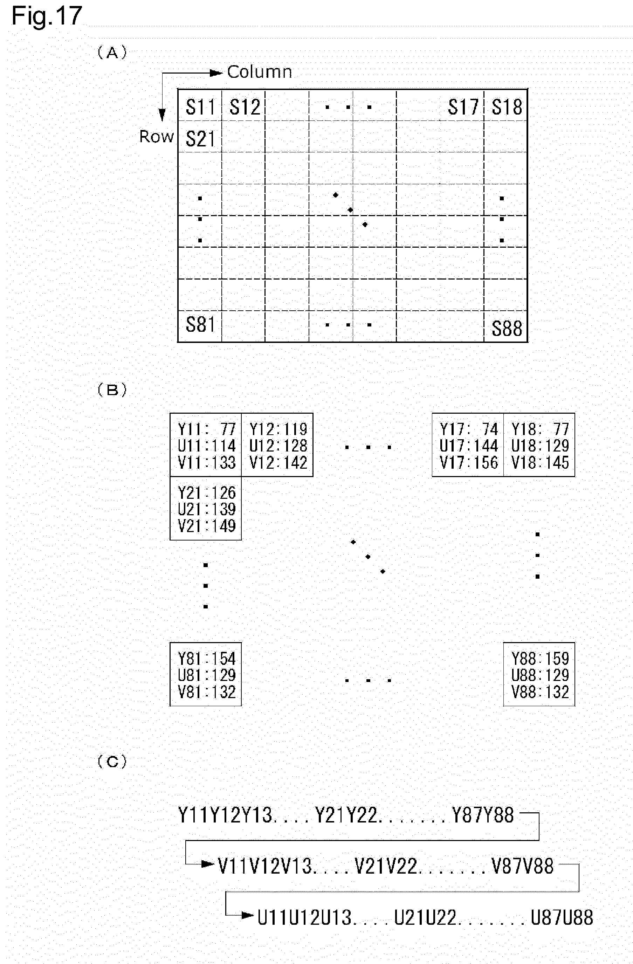

Fig. 17 is a diagram for describing an encoding method of a second embodiment. Image data will be described as an example of data to be encoded (target data). Configurations of a code generation device and a user device are similar to those of the first embodiment (see Figs. 6 and 7), and only an information processing method related to code generation and collation is different. Description of the device configuration is omitted, and an information processing method of code generation and collation will be described in detail.

As illustrated in Fig. 17(A), image data as target data (reference data) is divided into multiple sampling ranges. In the illustrated example, the sampling range is divided into sixty-four sampling ranges S11, S12, S13, ..., and S88 of eight rows and eight columns, but the number of divisions is not limited thereto. The total number of pixels included in each of the sampling ranges S11 to S88 is, for example, 1000 to 2000. Each pixel includes color information in YUV format based on a known format. Y represents a luminance value, U (Cb) represents a difference between the luminance value and the blue component, and V (Cr) represents a difference between the luminance value and the red component. Hereinafter, the respective values are referred to as a Y value, a U value, and a V value. This processing is executed by the sampling processing units 20 and 60.

At this time, an average value of the Y value, the U value, and the V value is obtained for each of the sampling ranges S11 to S88. The method of obtaining the average value is similar to that of the first embodiment described above, and for example, the sampling range S11 is obtained by obtaining a total value of the Y value, the U value, and the V value of all the pixels included in the sampling range S11 and dividing the total value by the total number of pixels of the sampling range S11. The same applies to other sampling ranges. This processing is executed by the feature value calculation units 21 and 61.

Fig. 17(B) illustrates an example of each average value of the Y value, the U value, and the V value in each sampling range. The average value of the Y value, the U value, and the V value in each sampling range is represented such that the average value of the Y value in the sampling range S11 is Y11, the average value of the U value is U11, and the average value of the V value is V11. For example, in the sampling range S12, the average values are Y12 = 119, U12 = 128, and V12 = 142.

The code is generated using the average values of the Y value, the U value, and the V value of each sampling range obtained as described above. As an example, as illustrated in Fig. 17(C), for example, the average values are concatenated in the order of Y values, U values, and V values, specifically in the order of Y11, Y12, Y13, ... Y21, Y22, ... Y87, Y88, U11, U12, U13, ... U21, U22, ... U87, U88, V11, V12, V13, ... V21, V22, ... Y87, and Y88. This is an example, and the combination order of the Y values, the U values, and the V values can be appropriately set. In this way, the reference code corresponding to the image data as the target data (reference data) is generated. This processing is executed by the encoding processing units 23 and 63.

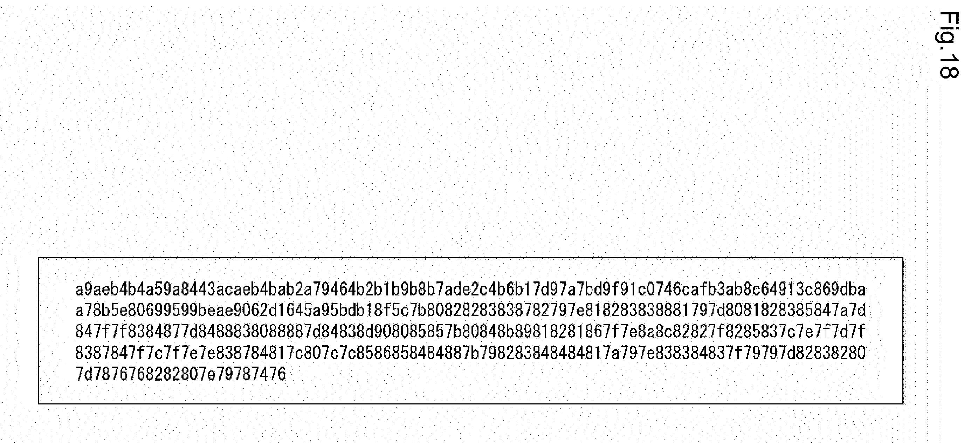

When each value of Y11 to Y88, U11 to U88, and V11 to V88 is represented by, for example, a character string in hexadecimal, the data size of the code obtained in a case where the sampling range of sixty-four divisions of eight rows and eight columns is set as described above is 192 bytes (64 × 3). This corresponds to text data of 384 characters. Fig. 18 illustrates an example of a code written in a character code in hexadecimal. In hexadecimal characters, the data amount per character is 4 bits, and thus the number of characters is 384, but the data amount at the time of recording is 192 bytes.

According to the study by the inventor of the present application, the data amount of 192 bytes is a practical minimum value for performing comparison, collation, determination, and recognition in real time without using complicated calculation. That is, the minimum value of an effective code that achieves a recognition rate of about 98% with respect to target data that can be visualized, such as a space, a scene, an object, a heat source video, a video, or an image, is 192 bytes. This data size does not depend on the area or data size of the original video or image.

For example, a data amount will be considered in a case where twenty-four codes are generated per second corresponding to a moving image with a frame rate of 24 fps. When the data size of the code corresponding to one image is 192 bytes as described above, the number of codes corresponding to the moving image for 30 minutes is 43200, and the data amount is about 7.9 MB. Similarly, the number of codes corresponding to a one-hour moving image is 86400 and the data amount is about 15.8 MB, the number of codes corresponding to a two-hour moving image is 172800 and the data amount is about 31.6 MB, and the number of codes corresponding to a one-day moving image is 2073600 and the data amount is about 379.7 MB. In addition, even if each piece of related information of coordinates (longitude/latitude/altitude: 24 bytes), a time (year/month/day and hour/minute/second: 8 bytes), and a comment of 100 2-byte characters (200 bytes) is added to each code, the data amount corresponding to the thirty-minute moving image is about 17.5 MB, the data amount corresponding to the one-hour moving image is about 34.9 MB, the data amount corresponding to the two-hour moving image is about 69.9 MB, and the data amount corresponding to the one-day moving image is about 838.5 MB. The data amount in a case where one code is generated corresponding to one frame per second is 1/24 as described above. In this case, the data amount of even a one-day moving image is as very small as 15.8 MB (without relevant information) or 34.9 MB (with relevant information).

In addition, since the code includes color information of each YUV, color information in an RGB format is obtained by the following conversion expression using the color information.

$$R = (1.164 \times (Y \text{ value} - 16)) + (1.596 \times (V \text{ value} - 128))$$

$$G = (1.164 \times (Y \text{ value} - 16)) - (0.391 \times (U \text{ value} - 128)) - (0.813 \times (V \text{ value} - 128))$$

$$B = (1.164 \times (Y \text{ value} - 16)) + (2.018 \times (U \text{ value} - 128))$$

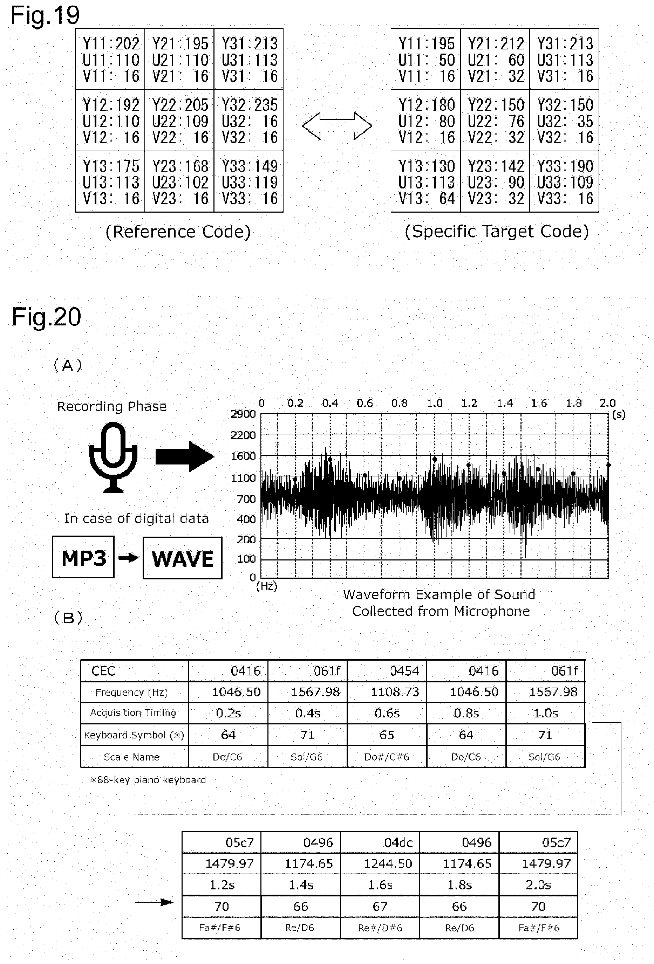

Fig. 19 is a diagram for describing a collation method using a code of the second embodiment. In order to simplify the description, a case where a sampling range of three rows and three columns is set is considered. In the drawing, a reference code generated and recorded in advance is illustrated on the left side, and a specific target code obtained from specific target data is illustrated on the right side. The actual state of each code is a character string as illustrated in Fig. 17(C) described above, but is expressed here so that correspondence for each sampling range can be easily understood. As the collation method, for example, a simple comparison method and a relative comparison method can be considered. These processes are executed by the collation processing unit 64.

First, a simple comparison method will be described. The difference between the Y value, the U value, and the V value of the reference code and the specific target code is obtained for each sampling range, and the difference is squared. For example, in the illustrated example, the square of the difference between the Y values in the sampling range of one row and one column is $(202 - 195)^2 = 49$. Similarly, the square of the difference between the Y values in the sampling range of one row and two columns is $(195 - 212)^2 = 289$. Similarly, for example, the square of the difference between the Y values in the sampling range of three rows and three columns is $(149 - 190)^2 = 1681$. Similarly, for other sampling ranges, the square of the difference between the Y values is obtained, and the total value thereof is obtained. In the illustrated example, the total value of the squares of the differences between the Y values in the respective sampling ranges is 15114 $(49 + 289 +...+ 1681)$. When the squares of the differences between the U values and the V values are summed in the same manner, the total values are 8694 and 3072, respectively.

When the total value corresponding to each of the Y value, the U value, and the V value is obtained in this manner, the total value is compared with a preset reference value, and when each value is equal to or less than the reference value, it is determined that the reference code and the specific target code match. The reference value may be set in consideration of the degree of similarity at which "matching" is to be made, and for example, a reference value corresponding to a matching rate of 97% or more can be set.

The reason why the difference is squared for each of the Y value, the U value, and the V value is to make it easier to detect the difference between the reference code and the specific target code. Depending on the application, the squaring may not be performed. Alternatively, the index may be further increased such as the cube.

Next, a relative comparison method will be described. First, for the reference code, a value Ya12 is obtained by squaring a difference in the Y value between the sampling range of one row and one column and the sampling range of one row and two columns. In the illustrated example, Ya12 = $(202 - 195)^2 = 49$. Similarly, values Ya13, Ya14, ..., and Ya19 obtained by squaring differences in Y values between the sampling range of one row and one column and the subsequent eight sampling ranges are obtained.

Next, a value Ya23 is obtained by squaring the difference in the Y value between the sampling range of one row and two columns and the sampling range of one row and three columns. In the illustrated example, Ya23 = $(195 - 213)^2 = 324$. Similarly, values Ya24, Ya25, ..., and Ya29 obtained by squaring differences in Y values between the sampling range of one row and two columns and the subsequent seven sampling ranges are obtained. Similarly, values Y34, Y35, ..., and Y49 obtained by squaring differences in Y values between the sampling range of one row and three columns and the subsequent sampling ranges are obtained.

Similarly in the following, values obtained by squaring differences in the Y values between the sampling range of two rows and one column and the subsequent sampling range, the sampling range of two rows and two columns and the subsequent sampling range, the sampling range of two rows and three columns and the subsequent sampling range, the sampling range of three rows and one column and the subsequent sampling range, and the sampling range of three rows and two columns and the subsequent sampling range are obtained.

Then, all values obtained by squaring the obtained differences of the Y values are summed. In the illustrated example, the total value is 47502. When the U value and the V value are similarly calculated, the total value related to the U value is 73256, and the total value related to the V value is 0.

Next, when the specific target code is calculated in the same manner as described above, the total value related to the Y value is 70898, the total value related to the V value is 58104, and the total value related to the U value is 18272.

Then, when the difference between the total values of YUV is obtained between the reference code and the specific target code, $\Delta Y = 23396$, $\Delta U = 15152$, and $\Delta V = 18272$ are obtained.

When the difference of the total value corresponding to each of the Y value, the U value, and the V value is obtained in this manner, the total value is compared with a preset reference value. When each value is equal to or less than the reference value, it is determined that the reference code and the specific target code match. The reference value may be set in consideration of the degree of similarity at which "matching" is to be made. For example, a reference value corresponding to a matching rate of 97% or more can be set.

Similarly to the simple comparison, the reason why the difference is squared for each of the Y value, the U value, and the V value is to make it easier to detect the difference between the reference code and the specific target code. Depending on the application, squaring does not necessarily need to be performed, and conversely, the index may be further increased by an operation such as cubing. Further, in the case of the relative comparison, the difference between a certain sampling range and the subsequent sampling range is obtained in the above example, but the difference may be obtained for each sampling range in a brute-force manner with all the other sampling ranges.

The code according to the second embodiment as described above can be applied to the various application examples described in the first embodiment. That is, although there is a difference in the code generation method between the first embodiment and the second embodiment, each application example relates to a utilization method of the generated code, and is not affected by the code generation method.

Third Embodiment

Fig. 20 is a diagram for describing an encoding method of a third embodiment. Sound data will be described as an example of data (target data) to be encoded. Configurations of a code generation device and a user device are similar to those of the first embodiment (see Figs. 6 and 7), and only an information processing method related to code generation and collation is different. Description of the device configuration is omitted, and an information processing method of code generation and collation will be described in detail.

In general, the three elements of sound are magnitude, pitch, and tone. The encoding of sound data is a technique which is not intended to reproduce sound itself, but is intended to perform, for example, recognition and identification of sound by analyzing sound data in real time. In the present embodiment, encoding is performed focusing on a pitch among three elements of sound.

Fig. 20(A) is an example of a waveform chart obtained by performing discrete Fourier transform on a sound collected from a microphone to obtain a temporal change in frequency. If necessary, the fundamental frequency may be calculated by cepstrum analysis. For such a waveform diagram, a sampling interval Q is set, for example, to 0.2 seconds, and the frequency is extracted for each sampling interval. Then, the extracted frequency value is encoded and recorded. At this time, the sampling interval Q, the sampling time (2.0 seconds in the illustrated example), and related data such as the title of the song are added and recorded. The sound data to be encoded may be obtained in real time by sound collection using a microphone, or may be collected and stored in advance. In a case where the format of the stored sound data is a compression format such as mp3, the sound data is appropriately converted into an uncompressed format such as a WAVE format, and encoding is executed.

In the above information processing, data division for each sampling interval is performed by the sampling processing unit 20, calculation of a frequency is performed by the feature value calculation unit 21, encoding is performed by the encoding processing unit 23, and recording of an obtained code and related information is performed by the code recording processing unit 24.

Fig. 20(B) is a diagram illustrating an example of encoding. In the drawing, an example is illustrated in which encoding is performed every 0.2 seconds on the basis of the waveform of the sound data illustrated in Fig. 20(A). For example, the frequency when the acquisition timing is 0.2 seconds is extracted as 1046.50 Hz, and the code corresponding thereto (denoted as CEC in the drawing) is obtained as 0416. This sound corresponds to Do/C6 in terms of scientific pitch, and corresponds to 64 in terms of keyboard symbols (in the case of the 88-key keyboard). The same applies to other acquisition timings. In this example, 20 Hz to 20000 Hz are assumed as an audible range at the time of extracting the frequency, and decimal places are discarded at the time of encoding. For example, in the case of 20.2 Hz, the value after decimal point rounding is 20, which is encoded in hexadecimal to be 14. Similarly, in the case of 261.62 Hz or the like, the value after decimal point rounding is 261, which is encoded in hexadecimal to be 105. Similarly, in the case of 20000.0 Hz or the like, the value after decimal point rounding is 20000, which is encoded in hexadecimal to be 4e20. Therefore, since the code generated in this embodiment can be expressed in hexadecimal of a maximum four characters, the data size is 2 bytes at maximum.

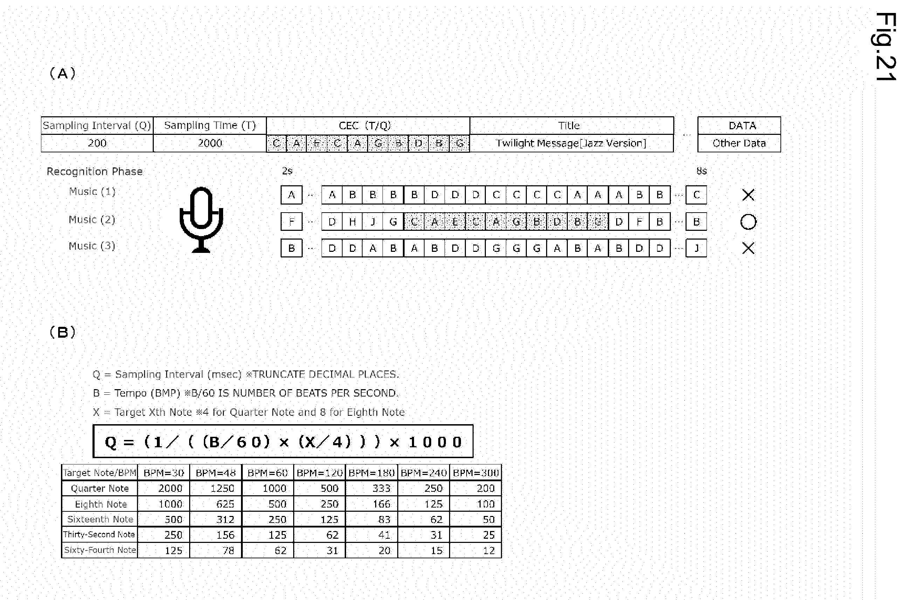

Fig. 21 is a diagram for describing a collation method using a code of the third embodiment. As illustrated in Fig. 21(A), a code corresponding to a pitch of a part (2000 ms) of a piece of music (Twilight Message) is obtained in advance by setting the sampling interval Q to 0.2 seconds, and is recorded as a reference code group. In the drawing, in order to simplify the description, the codes are represented by letters A to G, and the contents of the codes represented by the same letter coincide with each other. On the other hand, specific target data of each piece of music provided as real time (or sound data) is encoded, and this is collated with a reference data group. In the illustrated example, since there is no portion in which the arrangement of the reference data group and the code matches in each of a piece of music (1) and a piece of music (3), it can be determined that the piece of music is not the piece of music identified by the reference data group. On the other hand, since there is a portion in which the arrangement of the reference data group and the code matches in a piece of music (2), it is determined that the piece of music (2) is the music (Twilight Message) corresponding to the reference data group. Regarding the match/mismatch between the codes for each sampling interval Q, it may be determined as "match" when the codes are completely the same, or it may be determined as "match" when the codes are within a certain error range (for example, within an error range corresponding to ±10 Hz).

In the above information processing, data division for each sampling interval is performed by the sampling processing unit 60, calculation of the frequency is performed by the feature value calculation unit 61, encoding is performed by the encoding processing unit 63, and collation between the obtained code and the reference data group is performed by the collation processing unit 64.

In encoding the sound data, particularly when the target is the sound data of music, it is preferable to set the sampling interval in consideration of the tempo. For example, in the case of a music piece having a tempo (BPM) of 120, 120 quarter notes (beats) are included per minute. In this case, the interval of one beat, which is two beats per second, is 0.5 seconds. In this case, by setting (adjusting) the sampling interval in accordance with the tempo of the sound data, encoding corresponding to the timing of the note can be performed. Specifically, the sampling interval is Q, the tempo is B, and the length of the beat of the target note is X. The length of the beat of the note is set as, for example, X = 4 in the case of a quarter note, and X = 8 in the case of an eighth note. At this time, as illustrated in Fig. 21(B), the sampling interval Q can be expressed as $Q = (1/((B/60) \times (X/4)) \times 1000$. By encoding the sound data by setting the sampling interval Q using this relational expression, the determination accuracy of the similarity of the music is further improved. A specific value of the preferable sampling interval Q is exemplified in the lower column of Fig. 21 (B).

By such encoding of sound data, for example, control can be performed such that the title of a piece of music played in a space is displayed on the user device 2, or AR content (augmented reality content), a moving image, or a still image matching the music is displayed on the user device 2. In addition, regarding a so-called music plagiarism problem, it is also possible to present the similarity as an objective determination instead of a human subjective determination. In addition, in general, the heart sounds of living organisms are all different, and on the premise that the heart sounds are different even for twins, it is also possible to perform person authentication (heart sound authentication) based on the heart sounds by encoding the heart sounds. For example, unprecedented use cases can be created, such as enabling person authentication at gates such as airports.

According to each embodiment as described above, a novel technology for encoding target data such as an image and a sound with a small amount of data is provided. Accordingly, a novel technique capable of executing collation between specific target data and reference data with a low load and a short processing time is also provided.

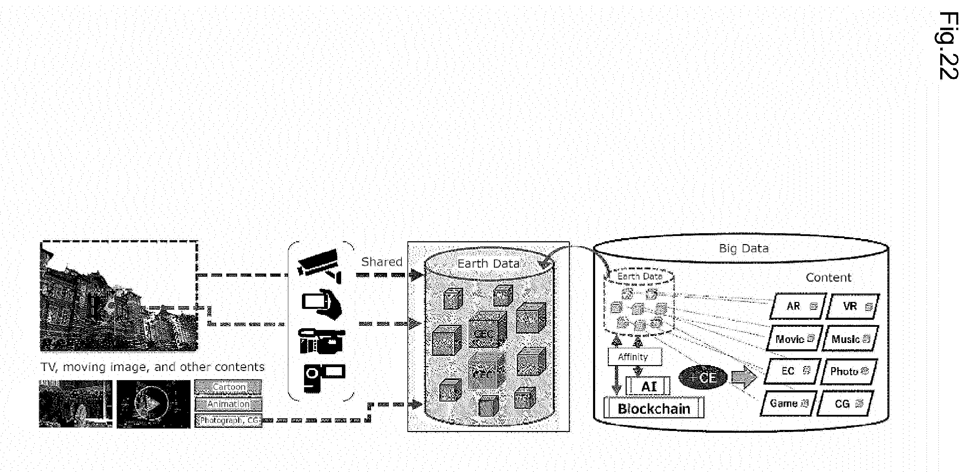

According to each embodiment, for example, it is possible to divide a video passing through a camera into any number of blocks, generate and record a unique code from information such as a light source, luminance, and color for each block (sampling range) of the divided blocks, and perform comparison, collation, and authentication at high speed (or in real time) using the code. By using this unique code, transmission of invisible information such as a heat source, a sound, or an X-ray, or five types of sensory information can be performed with a smaller data size. As illustrated in the conceptual diagram of Fig. 22, by adding a unique code according to each embodiment to data currently established and recognized as data, such as spatial information, a moving image, a still image, a temperature, and a sound, a new method of using data is created in addition to association with the real world, and a further added value and a further utilization method can be given to data already recorded and existing. For example, in addition to GPS information (position information), directions, angles, temperatures, pressures, and the like, various accompanying information such as an acquisition source and a URL already exist on big data. However, in a case where comparison and collation with the real world are performed in real time, "situation", "state", and "spatial data" necessary for determination are missing, and necessary association cannot be currently performed. On the other hand, by making a means of coupling "earth data" with the reality by using the code according to each embodiment, the code can serve as a "key" and a trigger of a link between the real world and the system. Since the data size of the code according to each embodiment is very small, a new concept of "byte chain" is provided.

The present invention is not limited to the contents of the above-described embodiments, and various modifications can be made within the scope of the gist of the present invention. The utilization method and application method of the code generated by each embodiment are not limited to the contents described above. In addition, the numerical values and the like mentioned in each embodiment are merely examples, and are not limited thereto. In the first embodiment, the relative difference between the sampling ranges is obtained, but the relative difference may be omitted, and the average value of the luminance in each sampling range may be concatenated as the character string data.

In each of the above embodiments, the code is generated by directly concatenating the character string data obtained from the average value or the relative difference, but the aspect of "connection" in the present invention is not limited thereto. For example, each average value or each relative difference multiplied by a certain coefficient may be converted into character string data and concatenated. In addition, the respective pieces of character string data may be concatenated in a form in which specific data (delimiter or the like) is interposed between the pieces of character string data corresponding to the respective average values or the like. Alternatively, character string data corresponding to each average value or the like may be converted into other character string data under a certain rule, and the converted character string data may be concatenated. That is, any form of concatenation is included in the concept of "concatenation" in the present invention as long as the mutual relative relationship such as the average value does not collapse or can be restored.

REFERENCE SIGNS LIST

10, 50...Information Processing Unit; 11, 51...Camera; 12, 52...Microphone; 13, 53...Storage Device; 14, 54...Operation Device; 15, 55... Display Device; 20, 60...Sampling Processing Unit; 21, 61...Feature Value Calculation Unit; 23, 63...Encoding Processing Unit; 24...Code Recording Processing Unit; 64...Collation Processing Unit

**Claims**

1. A code generation method for generating a code according to a content of target data using an information processing device, the method comprising:

   a step of dividing the target data into a plurality of sampling ranges;
   a step of obtaining, for each of the sampling ranges, an average value of at least one data element among one or more types of data element included in each of the sampling ranges, each data element being represented by a numerical value; and
   a step of generating a reference code corresponding to the target data by concatenating, as character string data, the average values of the respective sampling ranges or numerals of a predetermined number of digits from a top digit of the average values.

2. A code generation method for generating a code according to a content of target data using an information processing device, the method comprising:

   a step of dividing the target data into a plurality of sampling ranges;
   a step of obtaining, for each of the sampling ranges, an average value of at least one data element among one or more types of data element included in each of the sampling ranges, each data element being represented by a numerical value;
   a step of obtaining, for each of the sampling ranges, a relative difference calculated by dividing an average value of each of the sampling ranges by a sum of average values of the sampling ranges; and
   a step of generating a code corresponding to the target data by concatenating, as character string data, the relative differences of the respective sampling ranges or numerals of a predetermined number of digits from a top digit of the relative differences.

3. The code generation method according to claim 1 or 2, further comprising generating a database in which the code and additional data related to the target data are associated with each other.

4. The code generation method according to any one of claims 1 to 3, wherein the target data includes still image data, moving image data, or sound data.

5. The code generation method according to any one of claims 1 to 4, wherein the code is represented by character string data in hexadecimal.

6. A program that is executed by an information processing device and causes the information processing device to function as a device that generates a code according to a content of target data, the program causing the information processing device to execute:

   a step of dividing the target data into a plurality of sampling ranges;
   a step of obtaining, for each of the sampling ranges, an average value of at least one data element among one or more types of data element included in each of the sampling ranges, each data element being represented by a numerical value; and
   a step of generating a code corresponding to the target data by concatenating, as character string data, the average values of the respective sampling ranges or numerals of a predetermined number of digits from a top digit of the average values.

7. A program that is executed by an information processing device and causes the information processing device to function as a device that generates a code according to a content of target data, the program causing the information processing device to execute:

   a step of dividing the target data into a plurality of sampling ranges;
   a step of obtaining, for each of the sampling ranges, an average value of at least one data element among one or more types of data element included in each of the sampling ranges, each data element being represented by a numerical value;
   a step of obtaining, for each of the sampling ranges, a relative difference calculated by dividing an average value of each of the sampling ranges by a sum of average values of the sampling ranges; and
   a step of generating a code corresponding to the target data by concatenating, as character string data, the relative differences of the respective sampling ranges or numerals of a predetermined number of digits from a top digit of the relative differences.

8. A code generation device for generating a code according to a content of target data, the device comprising:

   a dividing unit that divides the target data into a plurality of sampling ranges;
   an average value calculation unit that obtains, for each of the sampling ranges, an average value of at least one data element among one or more types of data element included in each of the sampling ranges, each data element being represented by a numerical value; and
   a code generation unit that generates a code corresponding to the target data by concatenating, as character string data, the average values of the respective sampling ranges or numerals of a predetermined number of digits from a top digit of the average values.

9. A code generation device for generating a code according to a content of target data, the device comprising:

   a dividing unit that divides the target data into a plurality of sampling ranges;
   an average value calculation unit that obtains, for each of the sampling ranges, an average value of at least one data element among one or more types of data element included in each of the sampling ranges, each data element being represented by a numerical value;
   a relative difference calculation unit that obtains, for each of the sampling ranges, a relative difference calculated by dividing an average value of each of the sampling ranges by a sum of average values of the sampling ranges; and
   a code generation unit that generates a code corresponding to the target data by concatenating, as character string data, the relative differences of the respective sampling ranges or numerals of a predetermined number of digits from a top digit of the relative differences.

10. A data collation method using the method according to claim 1 or 2, the data collation method comprising:

   a step of acquiring, by the method, a reference code that is the code obtained according to reference data as the target data;
   a step of generating, by the method, a specific target code that is the code corresponding to specific target data as the target data; and
   a step of comparing the reference code and the specific target code to determine a match/mismatch between the reference code and the specific target code.

# Fig.1

（A）

（B）

|  |  |  |
|---|---|---|
| S1 | S2 | S3 |
| S4 | S5 | S6 |
| S7 | S8 | S9 |

（C）

| S1 | S2 | S3 |
|---|---|---|
| A1：128 | A2：086 | A3：134 |
| S4 | S5 | S6 |
| A4：101 | A5：068 | A6：101 |
| S7 | S8 | S9 |
| A7：115 | A8：091 | A9：121 |

（D）

| S1 | S2 | S3 |
|---|---|---|
| A1：128 | A2：086 | A3：134 |
| V1：13.54 | V2：9.10 | V3：14.17 |
| S4 | S5 | S6 |
| A4：101 | A5：068 | A6：101 |
| V4：10.68 | V5：7.19 | V6：10.68 |
| S7 | S8 | S9 |
| A7：115 | A8：091 | A9：121 |
| V7：12.16 | V8：9.62 | V9：12.80 |

（E）

13540910141710680719106812160962 1280

Fig.2

| No. | Code | Content |
|-----|------|---------|
| 01 | 2110······ | Image 1 |
| 02 | 1053······ | Image 2 |
| 03 | 8943······ | Image 3 |
| ⋮ | ⋮ | ⋮ |
| 37 | 8841······ | Image 37 |
| ⋮ | ⋮ | ⋮ |

Fig.3

Image
(Target Data)

↓ Encoding

8841······

Collation ⟺

Database

| ⋮ | | |
|---|---|---|
| 37 | 8841······ | Image 37 |
| ⋮ | | |

Out put result

Content corresponding to image is identified as image 37

# Fig.4

| Sampling Range | S1 | S2 | S3 | S4 | S5 | S6 | S7 | S8 | S9 |
|---|---|---|---|---|---|---|---|---|---|
| Reference Code (A) | 1354 | 0910 | 1417 | 1068 | 0719 | 1068 | 1216 | 0962 | 1280 |
| Specific Target Code (B) | 1368 | 0895 | 1417 | 1080 | 0700 | 1051 | 1201 | 0962 | 1262 |
| Difference (A - B) | -14 | +15 | 0 | -12 | +19 | +17 | +15 | 0 | +18 |

(A)

| Sampling Range | S1 | S2 | S3 | S4 | S5 | S6 | S7 | S8 | S9 |
|---|---|---|---|---|---|---|---|---|---|
| Reference Code (A) | 1354 | 0910 | 1417 | 1068 | 0719 | 1068 | 1216 | 0962 | 1280 |
| Specific Target Code (C) | 1280 | 1011 | 1390 | 1068 | 0980 | 1030 | 1090 | 1211 | 1007 |
| Difference (A - C) | +74 | -101 | +27 | 0 | -261 | +38 | +126 | -249 | +273 |

(B)

# Fig.5

Fig.6

Camera **11**  Microphone **12**  Storage Device **13**

Information Processing Unit **10**

Sampling Processing Unit **20**

Feature Value Calculation Unit **21**

Encoding Processing Unit **23**

Code Recording Processing Unit **24**

Operation Device **14**  Display Device **15**

1

Fig.7

51       52       53

| Camera | Microphone | Storage Device |

50

Information Processing Unit

| Sampling Processing Unit | ~ 60 |

| Feature Value Calculation Unit | ~ 61 |

| Encoding Processing Unit | ~ 63 |

| Collation Processing Unit | ~ 64 |

| Operation Device | | Display Device |

54       55

2

Fig.8

204

201       202

| C P U | R O M | Storage Device |
| | | Program ~ 206 |

| R A M | External I/F |

203       205

Fig.9

（A）

```
        START
          │
          ▼
  Input target data          S11
          │
          ▼
  Sampling processing        S12
          │
          ▼
  Calculate average value    S13
          │
          ▼
  Calculate relative difference  S14
          │
          ▼
  Coding processing          S15
          │
          ▼
  Database generation        S16
  and recording
          │
          ▼
         End
```

（B）

```
        START
          │
          ▼
  Input specific target data  S21
          │
          ▼
  Sampling processing        S22
          │
          ▼
  Calculate average value    S23
          │
          ▼
  Calculate relative difference  S24
          │
          ▼
  Coding processing          S25
          │
          ▼
  Collation processing       S26
          │
          ▼
         End
```

# Fig.10

(A)

300

(B)

FaceID：xxxxx_CEC

| | | | | |
|---|---|---|---|---|
| Code 8 | Code 7 | Code 6 | Code 9 | Code 10 |
| Code 3 | Code 2 | Code 1 | Code 4 | Code 5 |
| Code 13 | Code 12 | Code 11 | Code 14 | Code 15 |

## Fig.11

(A)

| A<br>A_Code | B<br>B_Code | C<br>C_Code | D<br>D_Code |
|---|---|---|---|
| E<br>E_Code | F<br>F_Code | G<br>G_Code | H<br>H_Code |
| I<br>I_Code | J<br>J_Code | K<br>K_Code | L<br>L_Code |

$N = n \times n'$  400

n

n'

(B)

410

400

| E | F |
|---|---|
| I | J |

(C)

Reference Code

A_Code
·
·
·
E_Code
F_Code
G_Code
H_Code
I_Code
J_Code
·
·
·

⬅ Collate Specific
Target Code

$N = 12$
$T = 4, F = 8$

Fig.12

（A）

（B）

（C）

a : 24
b : 13

a>b
⇒  a is upper, b is lower

Fig.13

（A）

600

（B）

612     610

（C）

612     610

Fig.14

(A)

700

(B)

701    700    702

(C)

NG    OK    NG    OK

710    711    712    713

Fig.15

（A）

800

（B）

801

800

（C）

810

810

## Fig.16

（A）

| Cd11 | Cd12 | Cd13 | Cd14 | Cd15 | Cd16 | Cd17 | Cd18 | Cd19 |
|------|------|------|------|------|------|------|------|------|
| Cd21 | Cd22 | Cd23 |      |      |      |      |      |      |
| Cd31 | Cd32 |      |      |      |      |      |      |      |
| Cd41 |      |      |      |      |      |      |      | . |
| Cd51 |      |      |      | ♦    |      |      |      | . |
| Cd61 |      |      |      | ♦    |      |      |      | . |
| Cd71 |      |      |      |      |      |      |      |   |
| Cd81 |      |      |      |      |      |      |      |   |
| Cd91 |      |      | .  .  . |   |      |      |      | Cd99 |

（B）

901  902  903

900

# Fig.17

(A)

Column →

| S11 | S12 | | · · · | | S17 | S18 |
|-----|-----|---|-------|---|-----|-----|
| S21 | | | | | | |
| | | | | | | |
| | | | | | | |
| | | | | | | |
| | | | | | | |
| | | | | | | |
| S81 | | | · · · | | | S88 |

Row ↓

(B)

| Y11: 77<br>U11:114<br>V11:133 | Y12:119<br>U12:128<br>V12:142 | · · · | Y17: 74<br>U17:144<br>V17:156 | Y18: 77<br>U18:129<br>V18:145 |
|---|---|---|---|---|
| Y21:126<br>U21:139<br>V21:149 | | | | |

| Y81:154<br>U81:129<br>V81:132 | · · · | Y88:159<br>U88:129<br>V88:132 |
|---|---|---|

(C)

Y11Y12Y13....Y21Y22.......Y87Y88

→V11V12V13....V21V22.......V87V88

→U11U12U13....U21U22.......U87U88

Fig.18

a9aeb4b4a59a8443acaeb4bab2a79464b2b1b9b8b7ade2c4b6b17d97a7bd9f91c0746cafb3ab8c64913c869dba
a78b5e80699599beae9062d1645a95bdb18f5c7b8082828383878279fe8182838388817f97d808182838584f7a7d
847ff83384877d84888838088877d84838d9080858857b80848b8981828186f7f7e8a8c82827f828583f7c7e7f7d7f
8387847f7c7f7e7e8387848417c807c7c8586858484887b79828384848481fa797e8383848437f79797d82838280
7d787676828807e79787476

## Fig.19

| | | |
|---|---|---|
| Y11:202<br>U11:110<br>V11: 16 | Y21:195<br>U21:110<br>V21: 16 | Y31:213<br>U31:113<br>V31: 16 |
| Y12:192<br>U12:110<br>V12: 16 | Y22:205<br>U22:109<br>V22: 16 | Y32:235<br>U32: 16<br>V32: 16 |
| Y13:175<br>U13:113<br>V13: 16 | Y23:168<br>U23:102<br>V23: 16 | Y33:149<br>U33:119<br>V33: 16 |

| | | |
|---|---|---|
| Y11:195<br>U11: 50<br>V11: 16 | Y21:212<br>U21: 60<br>V21: 32 | Y31:213<br>U31:113<br>V31: 16 |
| Y12:180<br>U12: 80<br>V12: 16 | Y22:150<br>U22: 76<br>V22: 32 | Y32:150<br>U32: 35<br>V32: 16 |
| Y13:130<br>U13:113<br>V13: 64 | Y23:142<br>U23: 90<br>V23: 32 | Y33:190<br>U33:109<br>V33: 16 |

$\Longleftrightarrow$

(Reference Code)　　　　　　　　(Specific Target Code)

## Fig.20

(A)

Recording Phase

In case of digital data

MP3 → WAVE

Waveform Example of Sound
Collected from Microphone

(B)

| CEC | 0416 | 061f | 0454 | 0416 | 061f |
|---|---|---|---|---|---|
| Frequency (Hz) | 1046.50 | 1567.98 | 1108.73 | 1046.50 | 1567.98 |
| Acquisition Timing | 0.2s | 0.4s | 0.6s | 0.8s | 1.0s |
| Keyboard Symbol (※) | 64 | 71 | 65 | 64 | 71 |
| Scale Name | Do/C6 | Sol/G6 | Do#/C#6 | Do/C6 | Sol/G6 |

※88-key piano keyboard

| 05c7 | 0496 | 04dc | 0496 | 05c7 |
|---|---|---|---|---|
| 1479.97 | 1174.65 | 1244.50 | 1174.65 | 1479.97 |
| 1.2s | 1.4s | 1.6s | 1.8s | 2.0s |
| 70 | 66 | 67 | 66 | 70 |
| Fa#/F#6 | Re/D6 | Re#/D#6 | Re/D6 | Fa#/F#6 |

Fig.21

EP 4 344 068 A1

(A)

| Sampling Interval (Q) | Sampling Time (T) | CEC (T/Q) | Title | | DATA |
|---|---|---|---|---|---|
| 200 | 2000 | C A E C A G B D B G | Twilight Message[Jazz Version] | … | Other Data |

Recognition Phase

2s       8s

Music (1)   A .. A B B B B D D D C C C C A A A B B … C   ✕

Music (2)   F .. D H J G C A E C A G B D B G D F B … B   ◯

Music (3)   B .. D D A B A B D D G G G A B A B D D … J   ✕

(B)

Q = Sampling Interval (msec) ※TRUNCATE DECIMAL PLACES.

B = Tempo (BMP) ※B/60 IS NUMBER OF BEATS PER SECOND.

X = Target Xth Note ※4 for Quarter Note and 8 for Eighth Note

$$Q = (1/((B/60) \times (X/4))) \times 1000$$

| Target Note/BPM | BPM=30 | BPM=48 | BPM=60 | BPM=120 | BPM=180 | BPM=240 | BPM=300 |
|---|---|---|---|---|---|---|---|
| Quarter Note | 2000 | 1250 | 1000 | 500 | 333 | 250 | 200 |
| Eighth Note | 1000 | 625 | 500 | 250 | 166 | 125 | 100 |
| Sixteenth Note | 500 | 312 | 250 | 125 | 83 | 62 | 50 |
| Thirty-Second Note | 250 | 156 | 125 | 62 | 41 | 31 | 25 |
| Sixty-Fourth Note | 125 | 78 | 62 | 31 | 20 | 15 | 12 |

Fig.22

## INTERNATIONAL SEARCH REPORT

| International application No. |
| --- |
| **PCT/JP2022/015433** |

**A. CLASSIFICATION OF SUBJECT MATTER**

*H03M 7/30*(2006.01)i; *G06T 1/00*(2006.01)i; *G06T 7/00*(2017.01)i; *G06T 9/00*(2006.01)i
FI: H03M7/30 Z; G06T1/00 300; G06T1/00 340A; G06T7/00 300F; G06T7/00 610; G06T7/00 660A; G06T9/00

According to International Patent Classification (IPC) or to both national classification and IPC

**B. FIELDS SEARCHED**

Minimum documentation searched (classification system followed by classification symbols)

H03M7/30; G06T1/00; G06T7/00; G06T9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

IEEE Xplore

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2003-67764 A (NIPPON TELEGR. & TELEPH. CORP.) 07 March 2003 (2003-03-07) paragraphs [0002]-[0006], [0043], [0057], fig. 1, 2, 21 | 1, 3-6, 8, 10 |
| A | | 2, 7, 9 |
| Y | JP 2000-165678 A (XEROX CORP.) 16 June 2000 (2000-06-16) paragraph [0011], fig. 2 | 1, 3-6, 8, 10 |
| Y | JP 2000-165676 A (XEROX CORP.) 16 June 2000 (2000-06-16) paragraph [0010], fig. 1 | 1, 3-6, 8, 10 |
| Y | JP 3221146 U (DISCO CORP.) 09 May 2019 (2019-05-09) paragraphs [0022]-[0027], fig. 2, 6 | 1, 3-6, 8, 10 |
| Y | JP 5-224713 A (KOYO ELECTRON. IND. CO., LTD.) 03 September 1993 (1993-09-03) paragraphs [0009], [0010], fig. 1 | 1, 3-6, 8, 10 |

☐ Further documents are listed in the continuation of Box C.      ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **30 May 2022** | **14 June 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2022/015433**

| Patent document cited in search report | | | Publication date (day/month/year) | Patent family member(s) | | | Publication date (day/month/year) |
|---|---|---|---|---|---|---|---|
| JP | 2003-67764 | A | 07 March 2003 | (Family: none) | | | |
| JP | 2000-165678 | A | 16 June 2000 | US paragraph [0024], fig. 2 EP | 2001/0041017 1001607 | A1 A2 | |
| JP | 2000-165676 | A | 16 June 2000 | EP paragraph [0025], fig. 2 | 997848 | A2 | |
| JP | 3221146 | U | 09 May 2019 | (Family: none) | | | |
| JP | 5-224713 | A | 03 September 1993 | (Family: none) | | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019028985 A